Europäisches Patentamt

European Patent Office

Office européen des brevets

(19)

(11) **EP 1 143 347 B1**

(12) **EUROPEAN PATENT SPECIFICATION**

(45) Date of publication and mention
of the grant of the patent:
**03.08.2005 Bulletin 2005/31**

(51) Int Cl.[7]: **G06F 17/13**

(21) Application number: **00107615.7**

(22) Date of filing: **08.04.2000**

(54) **System for solving differential equations with algebraic constraints**

System zur Lösung von Differentialgleichungen mit algebraischen Einschränkungen

Appareil pour résoudre des équations différentielles avec des contraintes algébriques

(84) Designated Contracting States:
**DE GB NL SE**

(43) Date of publication of application:
**10.10.2001 Bulletin 2001/41**

(73) Proprietor: **Deutsches Zentrum für Luft- und Raumfahrt e.V.**
**53175 Bonn (DE)**

(72) Inventor: **Mostermann, Pieter**
**82205 Gilching (DE)**

(74) Representative:
**von Kirschbaum, Albrecht, Dipl.-Ing.**
**Patentanwalt**
**Postfach 1520**
**82102 Germering (DE)**

(56) References cited:
**US-A- 5 629 845**          **US-A- 5 692 158**

• **KIEHL M: "A VECTOR IMPLEMENTATION OF AN ODE CODE FOR MULTI-POINT-BOUNDARY-VALUE PROBLEMS" PARALLEL COMPUTING,NL,ELSEVIER PUBLISHERS, AMSTERDAM, vol. 17, no. 2 / 03, 1 June 1991 (1991-06-01), pages 347-352, XP000297707 ISSN: 0167-8191**
• **KAMEL M S ET AL: "ODEXPERT AN EXPERT SYSTEM TO SELECT NUMERICAL SOLVERS FOR INITIAL VALUE ODE SYSTEMS" ACM TRANSACTIONS ON MATHEMATICAL SOFTWARE,US,ASSOCIATION FOR COMPUTING MACHINERY, NEW YORK, vol. 19, no. 1, 1 March 1993 (1993-03-01), pages 44-62, XP000445879 ISSN: 0098-3500**
• **MOSTERMAN P J ET AL: "A FORMAL HYBRID MODELING SCHEME FOR HANDLING DISCONTINUITIES IN PHYSICAL SYSTEM MODELS" PROCEEDINGS OF THE NATIONAL CONFERENCE ON ARTIFICIAL INTELLIGENCE AND THE INNOVATIVE APPLICATIONS OF ARTIFICIAL INTELLIGENCE CONFERENCE,XX,XX, vol. 2, 1996, pages 985-990, XP000869743**

EP 1 143 347 B1

**Description**

The present invention relates to a numerical simulation model structure of physical systems relying on differential equations supplemented by algebraic constraints on state variables.

For such systems, behavior trajectories are generated by numerical solvers that use integration algorithms such as, e.g. a Forward Euler and Runge-Kutta. These solvers require as input the system state and its gradient to evolve behavior over a desired interval of time. In this mathematical context, the system state represents a minimal set of variables that allows computation of the gradient of behavior evolution. In other words, the number of state variables matches the number of degrees of freedom of the system. Once the system state is known, all previous behavior of the differential and algebraic equations (DAE) is captured and future behavior can be derived.

From a physical modeling perspective, state variables correspond to energy storing elements, e.g., the charge stored by a capacitor in the electrical domain and the momentum stored by a mass in the mechanical domain. Behavior of those variables is expressed by a time derivative relation, e.g., for a mass $m$, $\dot{p} = F$, where $\dot{p}$ is the time derivative of the momentum and $F$ the force acting on the mass. These relations can be written in time integral form as well, requiring an initial value of which the modeler has specific knowledge, e.g. the initial charge on a capacitor or initial velocity of a mass. Therefore, these relations introduce a physical state.

In this patent application, the set of variables with modeled time derivative behavior, the physical state, is referred to as the extended set of state variables $X$. In case no algebraic constraints between those states exist, e.g. in the mechanical domain when there are no ideal rigid connections between masses, this extended set of state variables equals the set of state variables used by the numerical solver. However, in case of algebraic constraints between state variables in the extended set, their gradients cannot be computed without accounting for the effect of the algebraically related state variables. In effect, the algebraic equations constitute a manifold in state space to which behavior evolution is constrained.

Because of the direct, algebraic, relation between the state variables, they embody a reduced degree of behavioral freedom, and, therefore, a reduced set of state variables $X$ exists that completely specifies future behavior. This reduced set of state variables is supplied to the numerical solver to generate continuous behavior. Efficient algorithms exist to derive the reduced set of states from the extended set [Constantinos C. Pantelides: "The consistent initialization of differential-algebraic systems", SIAM Journal of Scientific and Statistical Computing, 9(2):213-231, March 1988].

When a DAE with a reduced number of states is to be simulated, it requires initial values for the state variables. However, the reduced state only has a partial bearing on the physical model that was designed from first principles. Therefore, there need not be a one to one correspondence between the requested initial values and the initial values of the physical model. In general, a user specified model may include a number of state variables that has to be reduced for numerical solvers to be able to simulate. The modeler typically has well defined knowledge about initial values of the chosen state variables, but the required use of a set of reduced states makes it difficult for the modeler to specify corresponding values related to the values of the initially chosen state variables.

The invention uses an algorithm to compute the initial value of the reduced set of state variables based on initial values of the state variables chosen by the modeler. This allows the modeler to specify intuitive and meaningful initial values for behavior generation. The initial values are computed using the instantaneous equivalent of the continuous dynamics as specified by the modeler, and, therefore, a mapping between the extended and reduced state variable values is achieved that is consistent with modeled dynamic behavior.

When algebraic constraints on state variables are present, a reduced state of the system has to be derived for numerical solvers to be able to generate correct behaviors. The invention eliminates the need for this step by applying the algorithm for deriving consistent state variable values after each integration time step. In this approach, the model with extended state variables is used by the numerical solver to calculate a first guess of state variable values without taking the algebraic constraints into account. These values are then corrected by using the same algorithm to derive consistent initial conditions.

In mixed-mode simulation, behaviors are generated for systems with piecewise continuous behavior. At well defined points in time, the DAE that describes continuous behavior evolution may change. This may cause discontinuous changes in gradients of behavior and discontinuous changes in the state variables that may be explicitly specified by the modeler, or implicitly result from algebraic constraints between state variables that become active.

When algebraic constraints between state variables become active, and the additional correction step is not applied, the computation of a reduced state may be required during simulation. In this case, the invention utilizes a generalized form of the algorithm used to compute initial state values for starting a simulation and applies this algorithm during simulation. In this setup, the specified values of the extended state are not user prescribed, but correspond to the final values of the previous piecewise continuous behavior, computed by the numerical solver.

The instantaneous equivalent of the equations that describe behavior in the new piecewise continuous interval is used to compute initial state variable values for this new behavior based on the inherent dynamics of the system.

Explicitly specified state variable value changes are described in the same form, allowing for direct integration into the overall system of equations to compute the consistent initial values.

Continuous behavior of dynamic systems is often modeled by differential equations supplemented by algebraic constraints. In its general form, this can be described by a system of equations

$$f(\dot{x}, x, u, t) = 0, \quad u \in \mathfrak{R}^k, \quad x \in \mathfrak{R}^m, \quad t \in \mathfrak{R}^+, \qquad (1)$$

where $u$ represents the known input variables, $x$ represents the unknowns, $\dot{x}$ represents the time derivatives of the unknowns, $t$ is the time, and $f$ is the time variant nonlinear relationship between the quantities. All quantities may be time variant, but their explicit time dependence is not shown.

In certain cases, Equation (1) can be written in explicit ordinary differential equation (ODE) form as

$$\dot{x} = f(x,u,t) \qquad (2)$$

which can be solved by numerical simulation algorithms ranging from a simple Forward Euler approach to complex Runge-Kutta methods. However, in many cases such an explicit formulation is not possible without algebraic manipulation of the relations. This occurs, e.g., when there are algebraic constraints on state variables, resulting in a system of equations of the form

$$f'(\dot{x},x,u,t) = 0 \qquad (3)$$

$$g(x,u,t)=0 \qquad (4)$$

where $f'$ is the function $f$ without the constraints in $g$. The function $g$ imposes restrictions on the behavior of $x$ and, therefore, decreases the number of degrees of freedom and corresponding state variables required for simulation of the system. Note that all variables $x$ in $g$ have a time derivative counterpart $\dot{x}$ in the function $f$. Variables that do not have a time derivative counterpart in a given system of equations will be referred to as $y$.

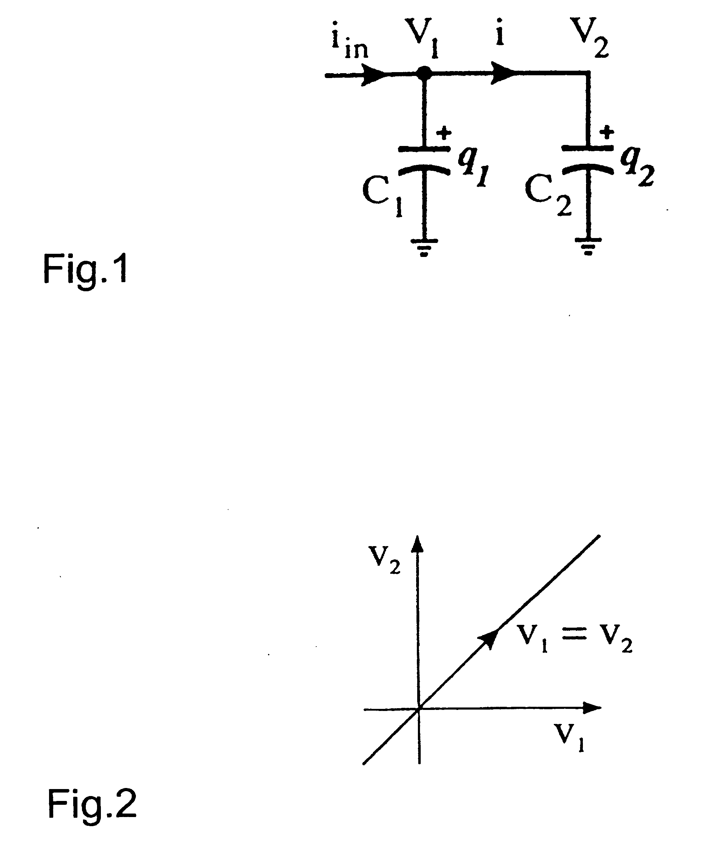

To illustrate, consider the two parallel capacitors in Fig.1. The voltage drop across the capacitors $C_1$ and $C_2$ is $v_1$ and $v_2$, respectively. The input variable is the current, $i_{in}$, the current into $C_2$ is $i$, and, therefore, the current into $C_1$ is $i_{in}$-$i$. The charge stored by $C_1$ and $C_2$ is $q_1$ and $q_2$, respectively. The system of equations for this circuit is

$$\begin{bmatrix} C_1 & 0 & 0 \\ 0 & C_2 & 0 \\ 0 & 0 & 0 \end{bmatrix} \begin{bmatrix} \dot{v}_1 \\ \dot{v}_2 \\ i \end{bmatrix} = \begin{bmatrix} 0 & 0 & -1 \\ 0 & 0 & 1 \\ 1 & -1 & 0 \end{bmatrix} \begin{bmatrix} v_1 \\ v_2 \\ i \end{bmatrix} + \begin{bmatrix} 1 \\ 0 \\ 0 \end{bmatrix} \begin{bmatrix} i_{in} \end{bmatrix}. \qquad (5)$$

After adding the top two rows, this can be written as

$$\begin{bmatrix} C_1 & C_2 \\ 0 & 0 \end{bmatrix} \begin{bmatrix} \dot{v}_1 \\ \dot{v}_2 \end{bmatrix} = \begin{bmatrix} 0 & 0 \\ 1 & -1 \end{bmatrix} \begin{bmatrix} v_1 \\ v_2 \end{bmatrix} + \begin{bmatrix} 1 \\ 0 \end{bmatrix} \begin{bmatrix} i_{in} \end{bmatrix} \qquad (6)$$

where the equation in the top row is in the form of Equation (3) and the bottom row in the form of Equation (4), i.e. this equation puts a constraint on the state variables $x$, with

$$x \quad = \quad \begin{bmatrix} v_1 \\ v_2 \end{bmatrix} \tag{7}$$

and the input variable

$$u = [\, i_{in} \,]. \tag{8}$$

The algebraic equations (in case of the two parallel capacitors $v_1 = v_2$) define a manifold in state space to which behavior evolution is confined. The numerical solver requires the gradient of behavior along this manifold. This gradient can be found numerically by relying on sophisticated error control, however, this may fail for complex constraints. Alternatively, the gradient can be explicitly calculated by algebraic manipulations prior to simulation. To this end, efficient algorithms exist that differentiate the algebraic constraints until a regular solvable system of equations is obtained [Constantinos C. Pantelides: "The consistent initialization of differential-algebraic systems", SIAM Journal of Scientific and Statistical Computing, 9(2):213-231, March 1988]. Simulation is performed using the reduced state vector with gradient along the manifold, combined with the algebraic constraints to determine the corresponding values of the original, higher dimension, state vector variables.

This is illustrated in Fig.2 for the two parallel capacitors in Fig.1. Behavior in the two dimensional state space is constrained to the one dimensional $v_1 = v_2$ manifold. Therefore, the system has one degree of freedom and the corresponding gradient is calculated by algebraic manipulations. Differentiating the bottom row in Equation (6) results in

$$\begin{bmatrix} C_1 & C_2 \\ 1 & -1 \end{bmatrix} \begin{bmatrix} \dot{v}_1 \\ \dot{v}_2 \end{bmatrix} \quad = \quad \begin{bmatrix} 1 \\ 0 \end{bmatrix} [i_{in}]. \tag{9}$$

which can be solved to give behavior evolution along the manifold as

$$\dot{v}_1 = \frac{i_{in}}{C_1 + C_2} \tag{10}$$

$$\dot{v}_2 = \frac{i_{in}}{C_1 + C_2} \tag{11}$$

and either one of these equations can be used to describe the reduced state behavior, which, combined with the $v_1 = v_2$ constraint, determines both modeled state variable values. In principle, Equation (10) and Equation (11) could be used simultaneously by the numerical solver, without the $v_1 = v_2$ constraint, but this results in a larger numerical error.

Once behavior evolution is on the manifold, the gradient in the newly derived system of equations ensures it remains there. However, the initial values of the modeled state variables that are algebraically related may be such that they are not on this manifold. Presently, two solutions are practiced:

- State of the art numerical solvers [Peter Kunkel, Volker Mehrmann, Werner Rath, and Jörg Weickert: "A new software package for linear differential-algebraic equations", SIAM Journal of Scientific Computing, 18(1):115-138, January 1997] may use a least mean square fit to project the initial state onto the nearest point of the manifold. In many cases, this projection violates the instantaneous equivalent of the inherent continuous dynamics. Therefore, the initial values used for simulation do not correspond to the desired behavior trajectory and may violate implicit physical principles. Furthermore, the modeler can only implicitly control the actual initial values used for simulation.
- In certain simulation tools, e.g., 20sim [Jan F. Broenink: "Modelling, simulation and analysis with 20-sim", Journal A, 38(3):22-25, January 1998, Special CACSD issue] and Dymola [H. Elmqvist, D. Brück, and M. Otter: "Dymola - User's Manual", Dynasim AB, Research Park Ideon, Lund, 1996], the modeler can only specify the initial values of the reduced set of state variables. In case the set of reduced state variables is a subset of the extended states

($X^r$ c $X$), there is a partial physical correspondence of a number of states only, and the modeler cannot initialize the remaining original state variables.

In both of these cases, the modeler has to compute manually initial values for the set of reduced state variables that are on the manifold, while ensuring that this computation corresponds to the modeled system dynamics and given initial values of the extended state. This is a cumbersome and error-prone activity, especially when the algebraic constraints that determine the manifold become complex and involve multiple state variables, i.e. are of high dimension.

In mixed-mode simulation, the issue manifests even more prominently because the initial values of the reduced state variables have to be computed during simulation based on the manifold projection. Mixed-mode simulation relies on different systems of equations to describe continuous behavior in piecewise intervals,

$$f_{\alpha_i}(\dot{x}, x, u, t) = 0 \tag{12}$$

where $\alpha_i$ indicates the interval of piecewise behavior to which the system of equations applies.

The function $f_{\alpha_i}$ may change because of external events and because of system variables crossing threshold values, internal events. External events are typically generated by time reaching a pre-specified threshold value (e.g. in batch control processes where stirring a mixture is required for a given time), and their time of occurrence is known a priori. Therefore, these can be handled efficiently. Internal events have to be detected and located with a desired accuracy during continuous integration (e.g., two masses that collide when their circumferences touch), and a number of algorithms exist to handle this.

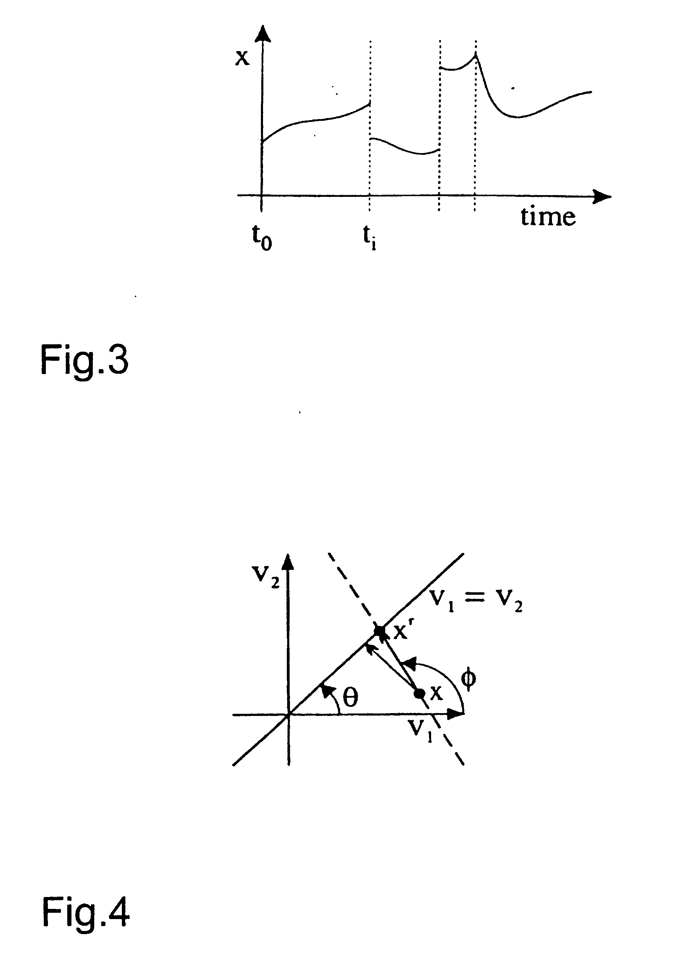

When algebraic constraints change during simulation, e.g. at $t_i$ in Fig.3, it is required to automatically find initial values for the reduced state vector of the new piecewise continuous behavior from the final values of the previous continuous behavior. Again, in case of explicit relations between state variables, this can be written as

$$f'_{\alpha_i}(\dot{x}, x, u, t) = 0 \tag{13}$$

$$g_{\alpha_i}(x, u, t) = 0 \tag{14}$$

for each piecewise interval $\alpha_i$, where $f'_{\alpha_i}$ is the function $f_{\alpha_i}$ without the constraints in $g_{\alpha_i}$. Now, a consistent mapping is required from the final state of continuous behavior in the interval $\alpha_{i-1}$ to the initial state in the interval $\alpha_i$. Furthermore, when discontinuous changes occur that are explicitly specified by the modeler, additional initialization equations are supplied.

Though efficient methods exist to compute the reduced set of state variables, these are cumbersome and difficult to apply, not in the least because of the required equation differentiation. Moreover, in case of variable structure systems, i.e. those with dynamically changing algebraic constraints that require mixed-mode simulation, the algebraic manipulations to derive the required state have to be performed during simulation and in compiled environments require a compilation stage during simulation, which is prohibitively inefficient.

It is an object of the invention to simplify the initialization of the simulation model requiring the calculation of consistent values for the reduced order and to mitigate the mentioned problems by considering all states to be independent and explicitly correcting the resulting error.

According to the present invention there is disclosed computer system containing a numerical simulation model structure of physical systems as defined in appended claim 1.

The simulator interface may handle a system in the general differential and algebraic equation (DAE) form

$$f(\dot{x}, x, u, t) = 0 \, ,$$

wherein $u$ represents the known input variables, $x$ represents the unknown variables, $\dot{x}$ represents the time derivatives of the unknown variables, $t$ is the time, and $f$ is the time variant nonlinear relationship between the quantities.

Further the simulator interface may handle a system in the case where explicit constraints on state variables $x$ exist

$$f'(\dot{x}, x, u, t) = 0$$

$$g(x, u, t) = 0,$$

wherein $u$ represents the known input variables, $x$ represents the unknown variables, $\dot{x}$ represents the time derivatives of the unknown variables, $t$ is the time, and $f'$ is the function $f$ of the time variant nonlinear relationship between the previous quantities without the constraints in the function $g$ imposing restrictions on the behavior of $x$.

Further the simulator interface may handle a system in the case where variables are present that do not have a time derivative counterpart $y$

$$f(\dot{x}, x, y, u, t) = 0,$$

wherein $u$ represents the known input variables, $x$ represents the unknown variables, $\dot{x}$ represents the time derivatives of the unknown variables, $t$ is the time, and $f$ is the time variant nonlinear relationship between the quantities.

Moreover the simulator interface may handle a system in the case where variables are present that do not have a time derivative counterpart $y$, and there are explicit constraints on the state variables $x$

$$f'(\dot{x},x,y,u,t) = 0$$

$$g(x,y,u,t) = 0,$$

wherein $u$ represents the known input variables, $x$ represents the unknown variables, $\dot{x}$ represents the time derivatives of the unknown variables, $t$ is the time, and $f'$ is the function $f$ of the time variant nonlinear relationship between the previous quantities without the constraints in the function $g$ imposing restrictions on the behavior of $x$.

Another aspect of said method according to this invention is characterized by using said simulator interface in the case, where algebraic constraints on these state variables change during mixed-mode simulation, to compute initial values for state variables $x^s$ in a system whose function describes behavior in different piecewise continuous intervals.

In this case, said simulator interface may handle a system in the general differential and algebraic equation (DAE) form

$$f_{\alpha_i}(\dot{x},x,u,t) = 0,$$

wherein $u$ represents the known input variables, $x$ represents the unknown variables, $\dot{x}$ represents the time derivatives of the unknown variables, $t$ is the time, and $f_{\alpha_i}$ are different functions describing behavior in different piecewise continuous intervals and being time variant nonlinear relationships between the quantities.

Further the simulator interface may handle a system in the case where explicit constraints on state variables $x$ exist

$$f'_{\alpha_i}(\dot{x},x,u,t) = 0$$

$$g_{\alpha_i}(x,u,t) = 0,$$

wherein $u$ represents the known input variables, $x$ represents the unknown variables, $\dot{x}$ represents the time derivatives of the unknown variables, $t$ is the time, and $f_{\alpha_i}$ are different functions describing behavior in different piecewise continuous intervals and being time variant nonlinear relationships between the previous quantities without the constraints in the function $g_{\alpha_i}$ imposing restrictions on the behavior of $x$.

Further the simulator interface may handle a system in the case where variables are present that do not have a time derivative counterpart $y$

$$f_{\alpha_i}(\dot{x},x,y,u,t) = 0,$$

wherein $u$ represents the known input variables, $x$ represents the unknown variables, $\dot{x}$ represents the time derivatives of the unknown variables, $t$ is the time, and $f_{\alpha_i}$ are different functions describing behavior in different piecewise continuous intervals and being time variant nonlinear relationships between the quantities.

Moreover the simulator interface may handle a system in the case where variables are present that do not have a time derivative counterpart $y$, and there are explicit constraints on the state variables $x$

$$f'_{\alpha_i}(\dot{x},x,y,u,t) = 0$$

$$g_{\alpha_i}(x,y,u,t) = 0,$$

wherein $u$ represents the known input variables, $x$ represents the unknown variables, $\dot{x}$ represents the time derivatives of the unknown variables, $t$ is the time, and $f_{\alpha_i}$ are different functions describing behavior in different piecewise continuous intervals and being time variant nonlinear relationships between the previous quantities without the constraints in the function $g_{\alpha_i}$ imposing restrictions on the behavior of $x$.

Another aspect of the computer system according to the present invention is characterized by using said simulator interface to compute values for the state variables $x$, the algebraic constraints being neglected to first compute a guess for the state variables $x$, and if the time derivatives of $x$ are underconstrained, equations of the form $\dot{x}_i = 0$ are added, applying a correction after one integration time step to calculate the new $x$ values without accounting for the algebraic constraints, the values calculated by this correction being consistent with said algebraic consistents.

In this case, said simulator interface may handle a system in the general differential and algebraic equation (DAE) form

$$f_{\alpha_i}(\dot{x},x,u,t) = 0,$$

wherein $u$ represents the known input variables, $x$ represents the unknown variables, $\dot{x}$ represents the time derivatives of the unknown variables, $t$ is the time, and $f_{\alpha_i}$ are different functions describing behavior in different piecewise continuous intervals and being time variant nonlinear relationships between the quantities.

Further the simulator interface may handle a system in the case where explicit constraints on state variables $x$ exist

$$f'_{\alpha_i}(\dot{x},x,u,t) = 0$$

$$g_{\alpha_i}(x,u,t) = 0,$$

wherein $u$ represents the known input variables, $x$ represents the unknown variables, $\dot{x}$ represents the time derivatives of the unknown variables, $t$ is the time, and $f_{\alpha_i}$ are different functions describing behavior in different piecewise continuous intervals and being time variant nonlinear relationships between the previous quantities without the constraints in the function $g_{\alpha_i}$ imposing restrictions on the behavior of $x$.

Further the simulator interface may handle a system in the case where variables are present that do not have a time derivative counterpart $y$

$$f_{\alpha_i}(\dot{x},x,y,u,t) = 0,$$

wherein $u$ represents the known input variables, $x$ represents the unknown variables, $\dot{x}$ represents the time derivatives of the unknown variables, $t$ is the time, and $f_{\alpha_i}$ are different functions describing behavior in different piecewise continuous intervals and being time variant nonlinear relationships between the quantities.

Moreover the simulator interface may handle a system in the case where variables are present that do not have a time derivative counterpart $y$, and there are explicit constraints on the state variables $x$

$$f'_{\alpha_i}(\dot{x},x,y,u,t) = 0$$

$$g_{\alpha_i}(x,y,u,t) = 0,$$

wherein $u$ represents the known input variables, $x$ represents the unknown variables, $\dot{x}$ represents the time derivatives of the unknown variables, $t$ is the time, and $f_{\alpha i}$ are different functions describing behavior in different piecewise continuous intervals and being time variant nonlinear relationships between the previous quantities without the constraints in the function $g_{\alpha i}$ imposing restrictions on the behavior of $x$.

Thus, when discontinuous changes occur that are explicitly specified by the modeler, additional initialization equations are supplied. The invented interface takes these constraints into account to find new initial values by using the continuous dynamics as specified by $f'_{\alpha i}$, i.e. behavior evolution for the new piecewise continuous interval.

The difference between generated mixed-mode behaviors by state of the art approaches and the invented interface is twofold:

- The initial conditions of the generated behavior may be different, and, therefore, the entire continuous behavior solution as computed by the numerical solver may differ.
- When multiple changes of $f'_{\alpha i}$ occur before continuous behavior evolution continues because the new consistent state variable values are such that thresholds are crossed, immediate further changes are invoked in the system of equations that describes behavior. In case the new initial values are not computed correctly, significant differences in generated behavior may ensue because incorrect continuous behavior equations are used.

The invention uses an algorithm to compute the initial value of the reduced set of state variables based on initial values of the state variables chosen by the modeler. This allows the modeler to specify intuitive and meaningful initial values for behavior generation. The initial values are computed using the instantaneous equivalent of the continuous dynamics as specified by the modeler, and, therefore, a mapping between the extended and reduced state variable values is achieved that is consistent with modeled dynamic behavior.

When algebraic constraints on state variables are present, a reduced state of the system has to be derived for numerical solvers to be able to generate correct behaviors. The invention eliminates the need for this step by applying the algorithm for deriving consistent state variable values after each integration time step. In this approach, the model with extended state variables is used by the numerical solver to calculate a first guess of state variable values without taking the algebraic constraints into account. These values are then corrected by using the same algorithm to derive consistent initial conditions.

In mixed-mode simulation, behaviors are generated for systems with piecewise continuous behavior. At well defined points in time, the DAE that describes continuous behavior evolution may change. This may cause discontinuous changes in gradients of behavior and discontinuous changes in the state variables that may be explicitly specified by the modeler, or implicitly result from algebraic constraints between state variables that become active.

When algebraic constraints between state variables become active, and the additional correction step is not applied, the computation of a reduced state may be required during simulation. In this case, the invention utilizes a generalized form of the algorithm used to compute initial state values for starting a simulation and applies this algorithm during simulation. In this setup, the specified values of the extended state are not user prescribed, but correspond to the final values of the previous piecewise continuous behavior, computed by the numerical solver.

The instantaneous equivalent of the equations that describe behavior in the new piecewise continuous interval is used to compute initial state variable values for this new behavior based on the inherent dynamics of the system. Explicitly specified state variable value changes are described in the same form, allowing for direct integration into the overall system of equations to compute the consistent initial values.

Further preferred features of the invention will appear from the claims 16 to 23.

The invented solution will now be described in more detail with reference to accompanying drawings in which:

Fig. 1    is a previously described circuit including two parallel capacitors;

Fig.2    is a previously described diagram illustrating an algebraic equations constrain behavior to a manifold;

Fig. 3    is a previously described diagram showing a mixedmode simulation;

Fig.4    is a diagram showing a comparison of projection onto a manifold;

Fig. 5    is a diagram showing a numerical integration using the instantaneous projection;

Fig.6    is a circuit in which algebraic constraints may change dynamically;

Fig.7    shows an elastic collision between two masses;

Fig.8    depicts an architecture realizing the method of the invention; and

Fig.9    shows the flow chart of an algorithm carrying out the operation of the simulator interface according to the invention.

The invented solution applies the instantaneous equivalent of the continuous dynamics as specified by the DAE to derive consistent initial conditions of the reduced set of state variables based on user specified initial values for the extended set of state variables.
Consistent state variable values are a point on the manifold of continuous behavior that is computed by applying the inherent dynamics of continuous behavior as an instantaneous projection to the specified initial state variable values.
Using the extended set of state variables for initialization greatly improves usability of simulation packages for DAE models that contain algebraic constraints between state variables.
To compute state variable values that are consistent with the continuous system dynamics, an instantaneous projection is required from the extended state, $x$, to the reduced state, $x^r$, as illustrated in Fig.4, before continuous simulation starts. This projection can be said to occur during an infinitesimal time interval from $t_0^-$ to $t_0$, where $t_0$ is the simulation start time and $t_0^-$ is a point in time immediately preceding to.
The DAE in Equation (3) can now be solved over this infinitesimal period of time.

$$\int_{t_0^-}^{t_0} f'(\dot{x}, x, u, t)dt = 0 \qquad (15)$$

Because integration is over an infinitesimal period of time, only the time derivatives of variables with a discontinuous change are nonzero, therefore, only $\dot{x}$ variables may have a nonzero value, *viz.,* $x(t_0)$-$x(t_0^-)$, which causes impulsive behavior of Methods for numerical simulation of physical systems relying on differential and algebraic equations (DAE)$\dot{x}$ if $x(t_0) \neq x(t_0^-)$. If no cross product terms with $\dot{x}$ are present in $f'$ and the input, $u$, has no impulsive component, this results in

$$f'\ (x(t_0)\text{-}x(t_0^-),0,0,t_0) = 0 \qquad (16)$$

where $x(t_0^-)$ are known as the modeler specified initial values and $f'$ represents the instantaneous field component at $t_0$. Combined with the algebraic constraints

$$g(x(t_0),u(t_0),t_0) = 0 \qquad (17)$$

it can be solved for $x(t_0)$, the desired initial values that are consistent with the algebraic constraints, and, therefore, on the manifold of state space behavior. Note that $x$ represents the extended state vector, and will be reduced to $x^r$ by accounting for $g$, either numerically or algebraically before simulation can be applied to generate behaviors. This results in the system of equations used for simulation that is of the form

$$f(\dot{x}^r, x^r, y, u, t) = 0 \qquad (18)$$

with $y$ the variables that have no time derivative counterpart. In the preferred approach, $x^r$ is chosen as a subset of $x$ such that $X = X^r \cap Y$.
Integration over an infinitesimal interval of time has been applied to time invariant semi-explicit systems with linear constraints to compute state variable values that are consistent with physical conservation principles. This invention applies the integration technique to systems in general to compute initial values consistent with inherent dynamics instead of systematically deriving physical conservation laws. It furthermore uses this technique as part of a numerical simulation system with an interface where it is the preferred approach to find a consistent projection. However, any other technique to find a projection consistent with the inherent dynamics may be applied in the interface that can be used in the framework of existing commercial simulation packages. For example, in many cases the constraints are explicitly incorporated by the modeler as physical conservation laws.

To illustrate the projection technique for the linear time invariant case, consider the two parallel capacitors in Fig. 1. Before continuous simulation can be started, consistent values of $v_1(t_0)$ and $v_2(t_0)$ have to be computed using initial values $v_1(t_0^-)$ and $v_2(t_0^-)$ as specified by the modeler. The DAE in Equation (6) contains the algebraic constraint $v_1(t_0) = v_2(t_0)$, and, therefore, discontinuous changes of $v_1$ and $v_2$ may occur. Consequently, the derivatives of both these variables that appear in $f$, may have nonzero values when integrated from $t_0^-$ to $t_0$, which yields

$$\begin{bmatrix} C_1 & C_2 \end{bmatrix} \int_{t_0^-}^{t_0} \begin{bmatrix} \dot{v}_1 \\ \dot{v}_2 \end{bmatrix} dt = 0 \qquad (19)$$

or,

$$\begin{bmatrix} C_1 & C_2 \end{bmatrix} \begin{bmatrix} v_1(t_0) - v_1(t_0^-) \\ v_2(t_0) - v_2(t_0^-) \end{bmatrix} = 0 . \qquad (20)$$

This equation is the result of using the substitution in Equation (16) for Equation (6). The constraint that the capacitor voltages are equal when continuous integration starts is

$$v_1(t_0) = v_2(t_0) \qquad (21)$$

and combined with Equation (20) $v_1(t_0)$ and $v_2(t_0)$ can be derived such that they are on the manifold of behavior

$$v_1(t_0) = v_2(t_0) = \frac{C_1}{C_1 + C_2} \left( C_1 v_1(t_0^-) + C_2 v_2(t_0^-) \right) \qquad (22)$$

Note that this derives the physical conservation of charge, q, constraint because $v = \frac{q}{C}$, and, therefore,

$$q_1(t_0) = \frac{C_1}{C_1 + C_2} \left( q_1(t_0^-) + q_2(t_0^-) \right) \qquad (23)$$

$$q_2(t_0) = \frac{C_2}{C_1 + C_2} \left( q_1(t_0^-) + q_2(t_0^-) \right) . \qquad (24)$$

So, $q_1(t_0) + q_2(t_0) = q_1(t_0^-) + q_2(t_0^-)$ and charge is conserved under the projection that was derived.

If $C_1 \neq C_2$, this projection differs from a least mean square fit, which, therefore, violates the inherent continuous dynamics modeled by the system as well as the macroscopic physical principle of conservation of charge. This is illustrated in Fig.2 where the projection that computes consistent values is along the dashed line with $\tan(\phi) = -\frac{C_1}{C_2}$ whereas the least mean square projection is along the line with $\tan(\theta) = -1$ perpendicular to $v_1 = v_2$.

After mapping the extended state variables onto the manifold, the interface uses these values to initialize the reduced states of the simulation model applied by the conventional initialization approaches described previously. The initialization based on a reduced number of states is now consistent since the projection on the manifold has become trivial. This makes the invented interface amenable to direct application in common simulation tools.

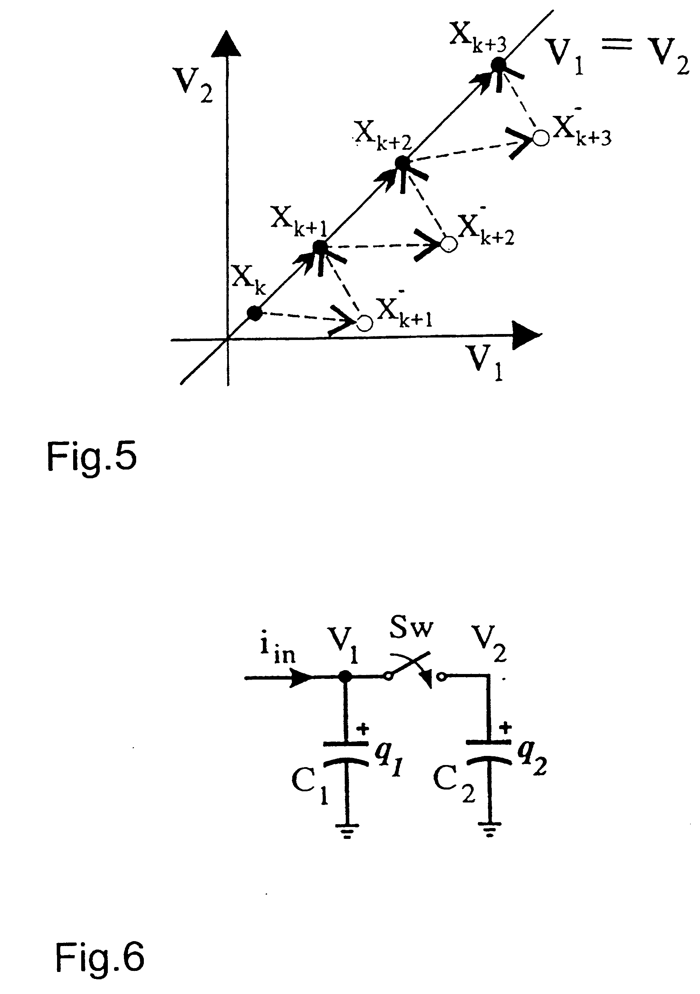

An additional feature of the invented interface is that it may be used to eliminate the need for algebraic manipulations to find a minimal set of state variables for simulation. This is implemented by using Equation (3) for numerical integration, neglecting the constraints between the state variables in Equation (4) After the numerical solver has computed an initial guess of the state variable values, $x^-_{k+1}$, a correction is applied that corresponds to the manifold projection to compute the actual values, $x_{k+1}$ (see Fig.5). This allows the use of even very simple integration methods without algebraic manipulations to formulate the system with a minimal set of states.

For the two capacitors $C_1$ and $C_2$, this means the top row in Equation (6) is used by the numerical solver without taking the constraint in the bottom row into account. Because the equation $C_1 \dot{v}_1 + C_2 \dot{v}_2 = i_{in}$ is underconstrained an additional default equation, $\dot{v}_2 = 0$, is chosen. This results in the explicit form

$$\begin{bmatrix} \dot{v}_1 \\ \dot{v}_2 \end{bmatrix} = \begin{bmatrix} \dfrac{1}{C_1} \, i_{in} \\ 0 \end{bmatrix} \qquad (25)$$

and this can be integrated over one integration step by any integration algorithm. Because of the neglected algebraic constraints, the new state values $x^-_{k+1}$, computed from $x_k$, are incorrect with respect to the actual model, see Fig.5, where $x^-_{k+1}$ is not on the manifold. This is corrected by taking the algebraic constraints into account in a consecutive step. In this example, Equation (22) is applied with $v_1(t^-_0)$ and $v_2(t^-_0)$ the guesses calculated by the numerical integration, $x^-_{k+1}$, illustrated in Fig.5. The dashed lines represent the sequence of integration computations and the empty circles intermediate points. The actual computed values of the state variables are represented by the solid circles.

Using this technique, mixed-mode simulation behavior generation is inherently facilitated and variable structure models with dynamically changing algebraic constraints can be conveniently solved. When algebraic constraints change, the only change to the system model is the instantaneous projection but the set of state variables remains unchanged, preventing complex algebraic manipulations.

A disadvantage of the approach is that sophisticated error control mechanisms built into numerical solvers operate on different dynamics than those of the actual system because the algebraic constraints are not accounted for, and, therefore, may not be accurate. Additionally, built-in root finding mechanisms of numerical solvers to detect and locate zero crossings cannot be used because they would operate on the first guess values, $x^-_k$. These disadvantages can be overcome by integrating the correction step into the numerical solver.

If the minimal order system is used by the numerical solver, the state projection may still be required when algebraic constraints change during simulation, e.g. a switch between two parallel capacitors, shown in Fig.6, may close at a certain time, $t_i$. Suppose that the interval of continuous behavior with the switch closed is described by the function $f_{\alpha_i}$, with algebraic constraints $g_{\alpha_i}$, starting at time $t_i$ and these algebraic constraints are different from those in the previous piecewise continuous interval, $g_{\alpha_{i-1}}$ (i.e., the switch was open). This may cause a discontinuous change in state variable values at $t_i$ corresponding to the projection onto the newly activated manifold, $g_{\alpha_i}$.

If a minimal order system is used for simulation, the instantaneous equivalent of the dynamics of the new continuous behavior can be used to find these consistent values. Similar to computing consistent initial values before starting simulation and at each integration time step, the discontinuous change is computed by integrating over an infinitesimal interval, that now ranges from $t^-_i$ to $t_i$. In other words, the instantaneous equivalent is derived for an infinitesimal period of time when the system of equations that describes the piecewise continuous behavior

$$\int_{t^-_i}^{t_i} f'_{\alpha_i}(\dot{x}, x, u, t)\, dt = 0 \qquad (26)$$

changes. In case no cross product terms with $\dot{x}$ and no impulsive inputs, $u$, are present, this yields

$$f'_{\alpha_i}\left(x(t_i) - x(t_i^-),0,0,\, t_i\right) = 0 \qquad (27)$$

where

$$x(t_i^-)$$

are the known values of the extended set of state variables in the previous piecewise continuous interval, $\alpha_{i-1}$, and $f'_{\alpha_i}$ is used to compute the instantaneous equivalent of the continuous dynamics that becomes active at $t_i$. Combined with the algebraic constraints

$$g_{\alpha_i}(x(t_i),u(t_i),t_i) = 0 \qquad (28)$$

it can be solved for $x(t_i)$, the desired initial values that are consistent with the algebraic constraints, and, therefore, on the manifold of state space behavior in the new piecewise continuous interval, $\alpha_i$.

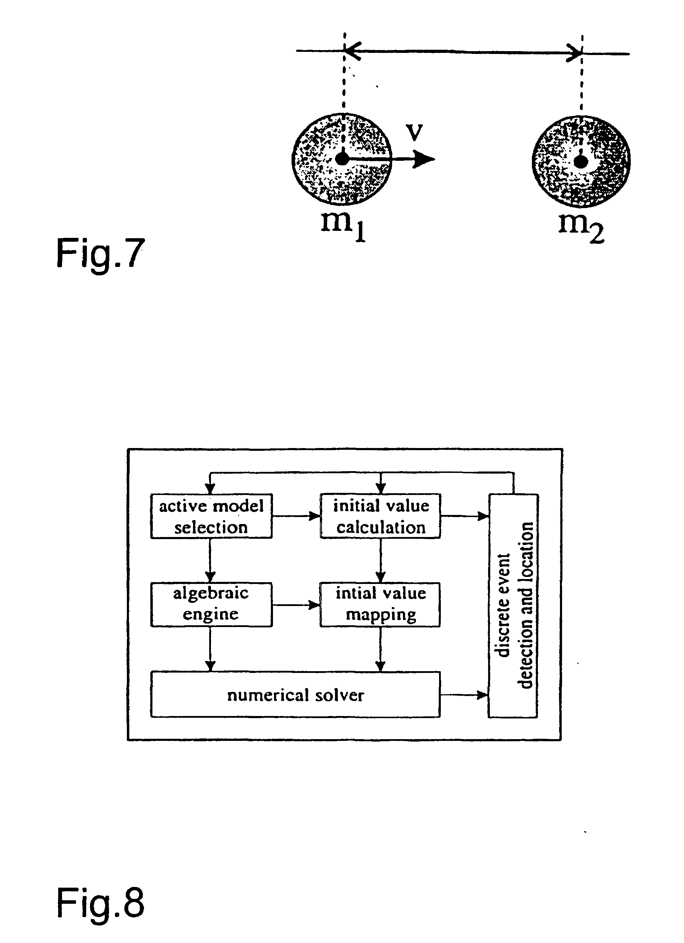

In certain cases, the modeler may wish to explicitly reinitialize state variables. For example, for an elastic collision between the two masses in Fig.7, Newton's collision rule states that the velocities $v_1$ and $v_2$ of masses $m_1$ and $m_2$, respectively, change according to

$$v_1 - v_2 = -\in\left(v_2^- - v_1^-\right) \qquad (29)$$

where $\in$ is the coefficient of restitution ($\in = 1$ for a perfectly elastic collision) and the values immediately before the collision are denoted by a '-' superscript. This instantaneous reinitialization can be represented in terms of an infinitely fast change from $v^-$ to $v$ over an infinitesimal interval used to compute the instantaneous vector field equation. So, the collision rule can be written as

$$v_2(t_i) - v_1(t_i) = -\in\left(v_2(t_i^-) - v_1(t_i^-)\right) \qquad (30)$$

In general, such explicit reinitialization constraints can be formulated as

$$h_{\alpha_i}\left(x(t_i),\, x(t_i^-),\, t_i\right) = 0 \qquad (31)$$

which seamlessly fits the resulting constraints after integrating $f'_{\alpha_i}$ from $\bar{t}_i$ to $t_i$, and, therefore, the combined system of equations can be solved in a straight-forward manner. Note that the modeler has responsibility not to overspecify the model, i.e. the number of unknowns and equations has to be the same.

This leads to Algorithm 1 for initializing state variables with algebraic constraints in general DAE systems of the form in Equation (3) and Equation (4). Note that initialization of a continuous simulator is a special case of initialization of a mixed-mode simulator.

Algorithm 1: Computing consistent initial values.

Require: active system of equations $f$

```
if simulation start time then
    request initial values of state x(t)
else
    request final values of state x(t) of previous
    integration step
end if
assign values of x(t) to x(t⁻)
if no cross product terms with ẋ and no impulsive u
then
    derive φ(x(t), x(t⁻)) = 0 from f'(x(t)−x(t⁻),0,0,t)=0
else
    derive φ(x(t), x(t⁻)) = 0 from ∫ₜ⁻ᵗ f'(ẋ, x, u, t)dt = 0
end if
compute x(t) from φ(x(t), x(t⁻)) = 0, g(x(t),u(t),t)=0
and h(x(t),x(t⁻),t)=0
```

In other work [Pieter J. Mosterman and Gautam Biswas: "A Java Implementation of an Environment for Hybrid Modelling and Simulation of Physical Systems", ICBGM99 pages 157-162, San Francisco, January 1999], consistent values are computed for hybrid bond graphs based on physical conservation principles. In a macroscopic view, extensive physical quantities such as charge, momentum, and mass are considered to be conserved. An iteration procedure applies this constraint to generate new initial values for a limited fixed set of element types with state behavior. This approach requires an interpretive graph distributed simulation approach which makes it not suitable for implementation in a compiled environment, and, also, makes it incompatible with existing commercial simulation packages.

The invented interface is not restricted to bond graph models, but more general and applies to user defined state variables. Also, it does not rely on iteration which may fail in certain cases and slow down simulation, but applies a more efficient analytic approach. Most importantly, the invented interface is compatible with commercial simulation packages, e.g., MATLAB, and can be used in conjunction with sophisticated existing numerical solvers.

In case the original DAE in Equation (1) cannot be partitioned into the form of Equation (3) and Equation (4), the method can be applied by integrating Equation (1) directly

$$\int_{t_0^-}^{t_0} f(\dot{x}, x, u, t)dt = 0 \qquad (32)$$

and when there are no cross products with $\dot{x}$ and no impulsive input, $u$, this results in

$$f\left(x(t_0) - x\left(t_0^-\right),0,0, t_o\right) = 0 \qquad (33)$$

which embodies the manifold constraints on $x$.

Furthermore, in case algebraic variables, $y$, are not yet solved for in the DAE in Equation (3) and Equation (4), the DAE can be written as

$$f'(\dot{x},x,y,u,t)=0 \qquad\qquad (34)$$

$$g(x,y,u,t)=0 \qquad\qquad (35)$$

where, again, time dependency of $x$, $y$, and $u$ is suppressed. Integrating Equation (34) results in

$$f'\left(x(t_0) - x(t_0^-),0, y(t_0),0, t_0\right) = 0 \qquad\qquad (36)$$

where because $y$ may be a function of $\dot{x}$, $y(t_0)$ may be a function of $(t_0) - x(t_0^-)$. This system of equations can again be solved for $x(t_0)$, and, therefore, $y(t_0)$, by adding the manifold equation

$$g(x(t_0),y(t_0),u(t_0),t_0)=0 \qquad\qquad (37)$$

This form is illustrated by the system of equations for the two parallel capacitors in Equation (5) with

$$x = \begin{bmatrix} v_1 \\ v_2 \end{bmatrix} \qquad\qquad (38)$$

$$y = [i] \qquad\qquad (39)$$

and

$$u = [i_{in}]. \qquad\qquad (40)$$

Now a preferred embodiment will be described.

It should be appreciated that although the preferred embodiment is described in term of a mixed-mode simulator, it also applies to finding consistent initial conditions for just continuous system simulation as well as to correct the state variable values at each integration time step. In the latter case, a discrete event to correct the state is invoked after each integration time step.

Fig.8 depicts the architecture of the invention. It consists of six modules:

- Active Model Selection: For each mode $\alpha_i$, this module selects the active set of equations $f_{\alpha_i}$, that describe continuous system behavior as well as the set of explicit reinitialization equations, $h_{\alpha_i}$.

- Initial Value Calculation: Given the active equations and current values of the extended set of system state variables, this module calculates new values for the state variables consistent with the instantaneous equations of the active continuous dynamic behavior.

- Algebraic Engine: This module manipulates the active model equations into a form with complexity that can be handled by the numerical solver that is used. If the extended set of state variables, $x$, is used, the algebraic constraints are neglected and state variable derivatives set to 0 until all state variable derivatives can be computed. If a minimal order system is used, differentiation of equations may be required to arrive at a reduced state vector, $x^r$. The resulting state vector that is used for simulation, either $x$ or $x^r$, is called $x^s$.

- Initial Value Mapping: This module maps the computed consistent initial values, $x$, onto the state vector for simulation, $x^s$, as determined by the system of equations that is supplied to the numerical solver.

- Numerical Solver: Given a system of equations and a set of initial states, this module generates continuous behaviors until a given stop time is reached or a discrete event is detected.

- Discrete Event Detection and Location: This module detects whether discrete events occur, locates their time of occurrence and the corresponding values of the system variables, $x$, and changes the system of active equations.

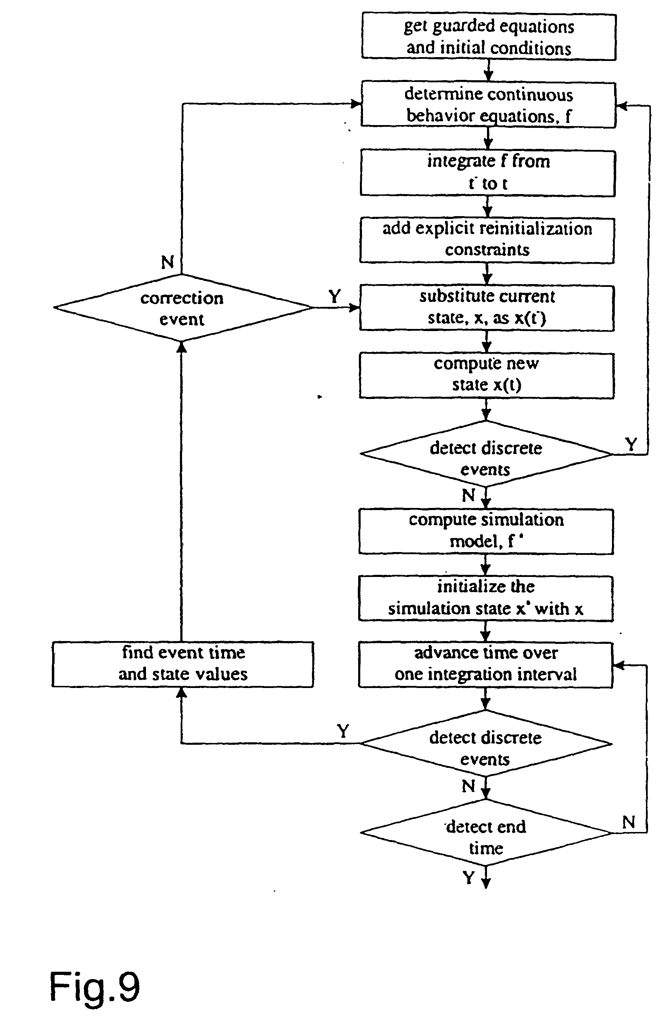

The execution algorithm is specified in Fig.9. First, the equations that describe system behavior have to be provided by the modeler by means of an input device. Often, this is a graphical model editor. The equations describing system behavior may be guarded by Boolean conditions activating and deactivating one or a set of equations. An equation with a guard that is true is active and is part of the present continuous model behavior definition. Next, the initial values for the modeler specified states, $x$, have to be provided. Typically, this is done by means of a dialog box of the simulation tool. In case of mixed-mode simulation with sequential logic that selects the active equations, the modeler has also to specify the initial values of the discrete states, $\sigma$.

After the continuous and discrete states are initialized, the values of the Boolean conditions that guard which equations are active are known, and the set of active equations can be compiled by the active model selection module. These equations may contain explicit reinitialization equations, and, furthermore, enforce algebraic constraints on modeler specified initial values. Therefore, the state variable values have to be computed that are consistent with the active set of equations. This is executed by the initial value calculation module which relies on Algorithm 1.

The new system state may consist of values that cause guards of the active equations to become false and also guards of inactive equations to become true. If this occurs, another discrete event is generated, and the new system of active equations is determined by the active model selection module. Again, the system state has to be made consistent with the system of active equations by the initial value calculation module. This process repeats until consistent values of the system state variables are derived that do not cause further Boolean value changes of the guards. To avoid a nonterminating loop, a counter may be implemented to monitor the iteration number and abort simulation when a critical value is reached.

If simulation is not aborted and no further discrete events occur, the use of a reduced number of states, $x^s = x^r$, requires the algebraic engine to manipulate the active system of equations to achieve complexity that the numerical solver can handle to generate continuous behaviors. In case of explicit integration routines in the solver, this means that an explicit ODE representation is required, whereas the availability of implicit integration routines with error control (such as e.g., DASSL) allow DAE systems with a certain complexity to be solved.

In the preferred implementation, the algebraic manipulations are such that a subset of the extended set of states is chosen as the reduced set of state variables. Then the initial value mapping module can initialize the reduced set of state variables by copying the consistent value of the corresponding state in the extended set. This is compatible with the approach taken by, e.g., 20sim and Dymola and allows for a straightforward implementation of the invented interface. Otherwise, the algebraic engine has to supply the algebraic relation between reduced states and the extended states.

If the extended set of states is used, $x^s = x$, the desired complexity is achieved by removing the algebraic constraints and choosing a number of state variables to have 0 time derivative, $\dot{x}_i = 0$, so that all $\dot{x}$ can be computed.

Now, the system of equations for simulation and the corresponding initial values of its states can be supplied to the numerical solver to advance time and generate a continuous behavior trajectory. The numerical solver is active until a discrete event occurs or the stop time is reached. While evolving in continuous time, the discrete event detection and location module monitors whether guards change their truth value or whether state correction is required to generate discrete events. If so, the current system variable values are reported to the initial value calculation module as the present state. If guards changed their truth value, the new guard values are used to select the new system of active equations by the active model selection module.

If state correction is required, the correction step is executed followed by detection whether guards changed their truth value. In this case, detection of truth value changes does not operate on the value as computed by the numerical solver at each integration time step. Instead, event detection only applies after the correction step has triggered the initial value calculation module to compute new consistent state variables. This implies that root finding functionality of the numerical solver to precisely locate the time the event occurred can not be exploited in this configuration. External root finding, e.g., by means of a bisectional search, has to be applied instead. Note that to increase efficiency, the simulation model, $f^s$, is not recomputed when numerical simulation was halted to correct the state vector values and no single guard changed its truth value.

This process continues until the numerical solver has reached the simulation end time as specified by the modeler.

It should be appreciated that the correction step can be integrated in the numerical solver. The numerical solver then takes two functions, one to compute the initial guess and the other to perform the correction. This novel approach to numerical simulation allows the projection technique to be integrated in a multi-step numerical integration algorithm.

The advantage of this is that the error control of the numerical solver operates on the consistent values instead of their guesses. Furthermore, improved performance can be achieved compared to the configuration where the correction is applied separately. Additionally, numerical solvers often have built-in event detection and location. If the correction is applied externally this mechanism has to be external as well. However, if the correction is integrated into the numerical solver, this facility can be exploited.

In the following the most important facts of the invention will be summed up.

Analysis of physical systems often relies on numerical simulation to generate behavior trajectories. This is achieved by numerical solvers that generate behaviors for a system model. The order of the system model is related to its number of state variables and initial values have to be provided for each of these states. In many cases, algebraic constraints exist between modeled states, causing a reduced number of degrees of freedom.

Therefore, the simulation model is of a lower order and there is no direct one-to-one correspondence between the modeled states and the states used for simulation. This complicates initialization of the simulation model by the modeler, because consistent values for the reduced order have to be calculated. This invention claims the use of a simulation interface for calculating consistent values for the reduced state by using inherent constraints in the simulation model. Models with algebraic constraints on the state variables have to be algebraically manipulated into a simulation model with a minimal number of state variables before it can be used by a numerical solver.

This invention claims a two-stage methodology for numerical simulation that avoids these manipulations. It uses the system model to (1) take one integration step while disregarding the algebraic constraints, followed by (2) a correction step that uses the technique for computing consistent initial values for the reduced state.

It also claims the integration of such a correction step into numerical solvers. In mixed-mode simulation, i.e., simulation of systems with piecewise continuous behavior, algebraic constraints may become active during simulation, requiring a consistent mapping of the system state onto the reduced state of the new piecewise behavior. The invented simulation interface uses the same technique to compute consistent initial values for the reduced state to compute consistent state variable values when such changes in the system occur during simulation.

**Claims**

**1.** Computer system containing a numerical simulation model structure of physical systems relying on differential equations supplemented by algebraic constraints on state variables representing physical quantities to generate behavior trajectories for a system model by numerical solvers, said system model being of a reduced order as to its number of modeled state variables $x$, that appear in time derivative form in the system of equations, said algebraic constraints imposing restrictions on the behavior of $x$ and therefore decreasing its number of degrees of freedom, and initial values being provided for each of these state variables $x$, whereby the provided initial values may be not consistent with said algebraic constraints, said system model structure comprising a simulator interface including six interacting modules, specifically:

- an active model selection module selecting for each mode $\alpha_i$ an active set of equations $f_{\alpha_i}$, that describe continuous system behavior as well as a set of explicit reinitialization equations, $h_{\alpha_i}$;
- an initial value calculation module calculating new values for the state variables consistent with the instantaneous equations of the active continuous dynamic behavior, provided that the active set of model equations and current values of the extended set of system state variables are given;
- an algebraic engine module manipulating said active model equations into a form with complexity that can be handled by the used numerical solver, said algebraic constraints being neglected and state variable derivatives being set to 0 until all state variable derivatives can be computed, if the extended set of state variables, $x$, is used, and differentiation of equations being required to arrive at a reduced state vector, $x^r$, if a minimal order system is used, the resulting state vector that is used for simulation, either $x$ or $x^r$, being called $x^s$;
- an initial value mapping module mapping the computed consistent initial values, $x$, onto the state vector for simulation, $x^s$, as determined by the system of equations that is supplied to said numerical solver;
- a numerical solver module generating continuous behaviors until a given stop time is reached or a discrete event is detected, provided that a system of equations and a set of initial states are given; and
- a discrete event detection and location module detecting whether discrete events occur, locating their time of occurrence and the corresponding values of the system variables, $x$, and changing the system of active equations;

wherein the output of said active model selection module is applied to the input of said initial value calculation module as well as to the input of said algebraic engine module, the output of said algebraic engine module is applied to the input of said initial value mapping module as well as to the input of said numerical solver module, the output of said initial value calculating module is applied to the input of said discrete event detection and location module as well as to the input of said initial value mapping module, the output of said initial value mapping module is applied to the input of said numerical solver module, the output of said numerical solver module is applied to the input of said discrete event detection and location module, and the output of said discrete event detection and location module is applied to the input of said active model selection module as well as to the input of said initial value calculation module,

and computing, based on the provided initial values of the modeled state variables $x$, initial values for state variables $x^s$ that are consistent with said algebraic constraints, by integrating said differential equations for said modeled state variables $x$ over an infinitesimal interval in time from $t_0^-$ to $t_0$, immediately preceding the start time $t_0$ of continuous behavior, leading to equations relating $x(t_0^-)$ and $x(t_0)$, where $x(t_0^-)$ are known as the provided initial values for the modeled state variables $x$ and $x(t_0)$ are the desired initial values of the state variables $x^s$ to be consistent with the algebraic constraints, and computing from these equations in combination with said algebraic constraints the $x(t_0)$.

2. Computer system according to claim 1, **characterized in that** said simulator interface handles a system in the general differential and algebraic equation (DAE) form

$$f(\dot{x}, x, u, t) = 0,$$

wherein $u$ represents the known input variables, $x$ represents the unknown variables, $\dot{x}$ represents the time derivatives of the unknown variables, $t$ is the time, and $f$ is the time variant nonlinear relationship between the quantities.

3. Computer system according to claim 1, **characterized in that** the simulator interface handles a system in the case where explicit constraints on state variables $x$ exist

$$f'(\dot{x}, x, u, t) = 0$$

$$g(x, u, t) = 0,$$

wherein $u$ represents the known input variables, $x$ represents the unknown variables, $\dot{x}$ represents the time derivatives of the unknown variables, $t$ is the time, and $f'$ is the function $f$ of the time variant nonlinear relationship between the previous quantities without the constraints in the function $g$ imposing restrictions on the behavior of $x$.

4. Computer system according to claim 1, **characterized in that** the simulator interface handles a system in the case where variables are present that do not have a time derivative counterpart $y$

$$f(\dot{x}, x, y, u, t) = 0,$$

wherein $u$ represents the known input variables, $x$ represents the unknown variables, $\dot{x}$ represents the time derivatives of the unknown variables, $t$ is the time, and $f$ is the time variant nonlinear relationship between the quantities.

5. Computer system according to claim 1, **characterized in that** the simulator interface handles a system in the case where variables are present that do not have a time derivative counterpart $y$, and there are explicit constraints on the state variables $x$

$$f'(\dot{x}, x, y, u, t) = 0$$

$$g(x, y, u, t) = 0,$$

wherein $u$ represents the known input variables, $x$ represents the unknown variables, $\dot{x}$ represents the time derivatives of the unknown variables, $t$ is the time, and $f'$ is the function $f$ of the time variant nonlinear relationship between the previous quantities without the constraints in the function $g$ imposing restrictions on the behavior of $x$.

**6.** Computer system according to claim 1, **characterized by** using said simulator interface in the case, where algebraic constraints on these state variables change during mixed-mode simulation, to compute initial values for state variables $x^s$ in a system whose function describes behavior in different piecewise continuous intervals.

**7.** Computer system according to claim 6, **characterized in that** the simulator interface handles a system in the general differential and algebraic equation (DAE) form

$$f_{\alpha_i}(\dot{x},x,u,t) = 0 \ ,$$

wherein $u$ represents the known input variables, $x$ represents the unknown variables, $\dot{x}$ represents the time derivatives of the unknown variables, $t$ is the time, and $f_{\alpha_i}$ are different functions describing behavior in different piecewise continuous intervals and being time variant nonlinear relationships between the quantities.

**8.** Computer system according to claim 6, **characterized in that** the simulator interface handles a system in the case where explicit constraints on state variables $x$ exist

$$f'_{\alpha_i}(\dot{x},x,u,t) = 0$$

$$g_{\alpha_i}(x,u,t) = 0,$$

wherein $u$ represents the known input variables, $x$ represents the unknown variables, $\dot{x}$ represents the time derivatives of the unknown variables, $t$ is the time, and $f_{\alpha_i}$ are different functions describing behavior in different piecewise continuous intervals and being time variant nonlinear relationships between the previous quantities without the constraints in the function $g_{\alpha_i}$ imposing restrictions on the behavior of $x$.

**9.** Computer system according to claim 6, **characterized in that** the simulator interface handles a system in the case where variables are present that do not have a time derivative counterpart $y$

$$f_{\alpha_i}(\dot{x},x,y,u,t) = 0,$$

wherein $u$ represents the known input variables, $x$ represents the unknown variables, $\dot{x}$ represents the time derivatives of the unknown variables, $t$ is the time, and $f_{\alpha_i}$ are different functions describing behavior in different piecewise continuous intervals and being time variant nonlinear relationships between the quantities.

**10.** Computer system according to claim 6, **characterized in that** the simulator interface handles a system in the case where variables are present that do not have a time derivative counterpart $y$, and there are explicit constraints on the state variables $x$

$$f'_{\alpha_i}(\dot{x},x,y,u,t) = 0$$

$$g_{\alpha_i}(x,y,u,t) = 0 \ ,$$

wherein $u$ represents the known input variables, $x$ represents the unknown variables, $\dot{x}$ represents the time derivatives of the unknown variables, $t$ is the time, and $f_{\alpha_i}$ are different functions describing behavior in different piecewise continuous intervals and being time variant nonlinear relationships between the previous quantities without the constraints in the function $g_{\alpha_i}$ imposing restrictions on the behavior of $x$.

**11.** Computer system according to claim 1, **characterized by** using said simulator interface to compute values for the state variables *x,* the algebraic constraints being neglected to first compute a guess for the state variables *x*, and if the time derivatives of *x* are underconstrained, equations of the form $\dot{x}_i = 0$ are added, applying a correction after one integration time step to calculate the new *x* values without accounting for the algebraic constraints, the values calculated by this correction being consistent with said algebraic consistents.

**12.** Computer system according to claim 11, **characterized in that** the simulator interface handles a system in the general differential and algebraic equation (DAE) form

$$f_{\alpha_i}(\dot{x},x,u,t) = 0,$$

wherein *u* represents the known input variables, *x* represents the unknown variables, $\dot{x}$ represents the time derivatives of the unknown variables, *t* is the time, and $f_{\alpha_i}$ are different functions describing behavior in different piecewise continuous intervals and being time variant nonlinear relationships between the quantities.

**13.** Computer system according to claim 11, **characterized in that** the simulator interface handles a system in the case where explicit constraints on state variables *x* exist

$$f'_{\alpha_i}(\dot{x},x,u,t) = 0$$

$$g_{\alpha_i}(x,u,t) = 0,$$

wherein *u* represents the known input variables, *x* represents the unknown variables, $\dot{x}$ represents the time derivatives of the unknown variables, *t* is the time, and $f_{\alpha_i}$ are different functions describing behavior in different piecewise continuous intervals and being time variant nonlinear relationships between the previous quantities without the constraints in the function $g_{\alpha_i}$ imposing restrictions on the behavior of *x*.

**14.** Computer system according to claim 11, **characterized in that** the simulator interface handles a system in the case where variables are present that do not have a time derivative counterpart *y*

$$f_{\alpha_i}(\dot{x},x,y,u,t) = 0,$$

wherein *u* represents the known input variables, *x* represents the unknown variables, $\dot{x}$ represents the time derivatives of the unknown variables, *t* is the time, and $f_{\alpha_i}$ are different functions describing behavior in different piecewise continuous intervals and being time variant nonlinear relationships between the quantities.

**15.** Computer system according to claim 11, **characterized in that** the simulator interface handles a system in the case where variables are present that do not have a time derivative counterpart *y*, and there are explicit constraints on the state variables *x*

$$f'_{\alpha_i}(\dot{x},x,y,u,t) = 0$$

$$g_{\alpha_i}(x, y, u, t) = 0,$$

wherein *u* represents the known input variables, *x* represents the unknown variables, $\dot{x}$ represents the time derivatives of the unknown variables, *t* is the time, and $f_{\alpha_i}$ are different functions describing behavior in different piecewise continuous intervals and being time variant nonlinear relationships between the previous quantities without the constraints in the function $g_{\alpha_i}$ imposing restrictions on the behavior of *x*.

**16.** Computer system according to any of claims 1 to 15, **characterized by** the integration of a correction step into a numerical solver by use of an additional correction function, this correction step operating on all intermediate integration points, including those that are not accepted by the solver because they would result in too large an error.

**17.** Computer system according to any of claims 1 to 16, **characterized by** a means for by-passing the simulator interface for initialization of the first piecewise continuous behavior to allow direct initialization of the simulator state variables by the modeler.

**18.** Computer system according to any of claims 6 to 15, **characterized by** a discrete event iteration mechanism in the simulation interface to ensure the system of active equations is consistent with the state variable values used to select the active system of equations.

**19.** Computer system according to any of claims 1 to 18, **characterized in that** the systems of equations are supplemented with explicit initialization constraints of the form

$$h_{\alpha_i}\left(x(t),\, x\left(t^-\right),\, t\right) = 0\,,$$

wherein $x(t^-)$ is the left limit value in time of $x(t)$.

**20.** Computer system according to claim 19, **characterized by** a mechanism to allow immediate further discrete events to be invoked to select a new system of equations $\alpha_{i+1}$, before advancing time by means of a numerical solver if equations of the form

$$h_{\alpha_i}\left(x(t),\, x\left(t^-\right),\, t\right) \doteq 0$$

are present.

**21.** Computer system according to any of claims 1 to 20, **characterized by** an interface for transferring the consistent initial values $x$ of the extended state to the state variables $x^s$ as used by the numerical solver, algebraically manipulating the system of equations before it is supplied to the numerical solver to be in explicit ODE (ordinary differential equation) form, or being a DAE of complexity that the numerical solver can handle, in case of a reduced set of states $x^r$ the preferred implementation takes a subset of $x$ as $x^r$, such that $X^r \subset X$, and in case another set of reduced states is chosen, the algebraic engine needs to supply the corresponding algebraic relations to be able to transfer the consistent initial conditions to the reduced state variables values.

**22.** Computer system according to any of claims 6 to 15, **characterized by** a simulation interface to mix DAEs in different form to be active during different stages $\alpha_i$ of the simulation, this operation including variables that change from being part of $X^r$ to being part of $Y$.

**23.** Computer system according to any of claims 6 to 15, **characterized by** a simulation interface to mix DAEs in different form and with different variables such that the number of extended state variables changes and the number of algebraic variables do not match, these systems requiring an explicit mapping between the variables in different intervals of operation $\alpha_i$.

**Patentansprüche**

**1.** Computersystem, das eine numerische Simulationsmodellstruktur physikalischer Systeme enthält, die auf Differentialgleichungen beruhen, die durch algebraische Zwangsbedingungen von Zustandsvariablen, die physikalische Größen darstellen, ergänzt sind, zum Erzeugen von Verhaltenstrajektorien für ein Systemmodell durch numerische Solver, wobei das Systemmodell von reduzierter Größenordnung ist, was seine Anzahl von modellierten Zustandsvariablen $x$ angeht, die in Zeitableitungsform im System von Gleichungen auftreten, wobei die algebraischen Zwangsbedingungen dem Verhalten von $x$ Einschränkungen auferlegen und daher seine Anzahl von Freiheitsgraden senken und wobei Anfangswerte für jede dieser Zustandsvariablen $x$ vorgesehen sind, wodurch die vorgesehenen Anfangswerte mit den algebraischen Zwangsbedingungen nicht konsistent sein können, wobei die Systemmodellstruktur eine Simulatorschnittstelle umfasst, die sechs aufeinander wirkende Module aufweist, nämlich:

- einen Aktivmodellauswahlmodul, der für jeden Modus $\alpha_i$ sowohl einen aktiven Satz von Gleichungen $f_{\alpha_i}$, die das stetige Systemverhalten beschreiben, als auch einen Satz von expliziten Neuinitialisierungsgleichungen $h_{\alpha_i}$ auswählt;
- einen Anfangswertberechnungsmodul, der neue Werte für die Zustandsvariablen berechnet, die mit den augenblicklichen Gleichungen des aktiven stetigen dynamischen Verhaltens konsistent sind, unter der Bedingung, dass der aktive Satz von Modellgleichungen und die laufenden Werte des erweiterten Satzes der Systemzustandsvariablen gegeben sind;
- einen algebraischen Werkzeugmodul, der die aktiven Modellgleichungen in eine Form mit einer Komplexität manipuliert, die durch den verwendeten numerischen Solver behandelt werden kann, wobei die algebraischen Zwangsbedingungen vernachlässigt werden und Zustandsvariablenableitungen auf 0 gesetzt werden, bis alle Zustandsvariablenableitungen berechnet werden können, wenn der erweiterte Satz von Zustandsvariablen $x$ verwendet wird, und wobei die Differenzierung von Gleichungen verlangt wird, um zu einem reduzierten Zustandsvektor $x^r$ zu gelangen, wenn ein minimales Ordnungssystem verwendet wird, wobei der resultierende Zustandsvektor, der für die Simulation verwendet wird, also entweder $x$ oder $x^r$, mit $x^s$ bezeichnet wird;
- einen Anfangswertabbildungsmodul, der die berechneten konsistenten Anfangswerte $x$ auf den Zustandsvektor $x^s$ zur Simulation abbildet, wie durch das System von Gleichungen ermittelt, das dem numerischen Solver zugeführt wird;
- einen numerischen Solvermodul, der stetige Verhalten erzeugt, bis eine gegebene Anhaltezeit erreicht oder ein diskretes Ereignis detektiert wird, unter der Bedingung, dass ein System von Gleichungen und ein Satz von Anfangszuständen gegeben sind; und
- einen Diskretereignisdetektions- und -auffindungsmodul, der detektiert, ob diskrete Ereignisse auftreten, ihre Auftrittszeit und die entsprechenden Werte der Systemvariablen $x$ auffindet und das System aktiver Gleichungen ändert;

wobei die Ausgangsgröße des Aktivmodellauswahlmoduls sowohl dem Eingang des Anfangswertberechnungsmoduls als auch dem Eingang des algebraischen Werkzeugmoduls zugeführt wird, die Ausgangsgröße des algebraischen Werkzeugmoduls sowohl dem Eingang des Anfangswertabbildungsmoduls als auch dem Eingang des numerischen Solvermoduls zugeführt wird, die Ausgangsgröße des Anfangswertberechnungsmoduls sowohl dem Eingang des Diskretereignisdetektions- und -auffindungsmoduls als auch dem Eingang des Anfangswertabbildungsmoduls zugeführt wird, die Ausgangsgröße des Anfangswertabbildungsmoduls dem Eingang des numerischen Solvermoduls zugeführt wird, die Ausgangsgröße des numerischen Solvermoduls dem Eingang des Diskretereignisdetektions- und -auffindungsmoduls zugeführt wird und die Ausgangsgröße des Diskretereignisdetektions- und -auffindungsmoduls sowohl dem Eingang des Aktivmodellauswahlmoduls als auch dem Eingang des Anfangswertberechnungsmoduls zugeführt wird,
und wobei auf der Grundlage der vorgesehenen Anfangswerte der modellierten Zustandsvariablen $x$ Anfangswerte für die Zustandsvariablen $x^s$, die mit den algebraischen Zwangsbedingungen konsistent sind, durch Integrieren der Differentialgleichungen für die modellierten Zustandsvariablen $x$ über ein infinitesimales Zeitintervall von $t_0^-$ bis $t_0$ unmittelbar vor der Startzeit $t_0$ des stetigen Verhaltens berechnet werden, was zu Gleichungen führt, die sich auf $x(t_0^-)$ und $x(t_0)$ beziehen, wobei $x(t_0^-)$ als die vorgesehenen Anfangswerte für die modellierten Zustandsvariablen $x$ bekannt sind und $x(t_0)$ die gewünschten Anfangswerte der Zustandsvariablen $x^s$ sind, die mit den algebraischen Zwangsbedingungen konsistent sein sollen, und aus diesen Gleichungen in Kombination mit den algebraischen Zwangsbedingungen die Größe $x(t_0)$ berechnet wird.

2. Computersystem nach Anspruch 1, **dadurch gekennzeichnet, dass** die Simulatorschnittstelle ein System in der allgemeinen differential-algebraischen Gleichungsform (Differential and Algebraic Equation; DAE)

$$f(\dot{x},\, x,\, u,\, t) = 0$$

behandelt, wobei $u$ die bekannten Eingangsvariablen darstellt, $x$ die unbekannten Variablen darstellt, $\dot{x}$ die Zeitableitungen der unbekannten Variablen darstellt, $t$ die Zeit ist und $f$ die zeitvariante nichtlineare Beziehung zwischen den Größen ist.

3. Computersystem nach Anspruch 1, **dadurch gekennzeichnet, dass** die Simulatorschnittstelle ein System im Fall behandelt, in dem explizite Zwangsbedingungen für die Zustandsvariablen $x$ bestehen

$$f'(\dot{x}, x, u, t) = 0$$

$$g(x, u, t) = 0,$$

wobei $u$ die bekannten Eingangsvariablen darstellt, $x$ die unbekannten Variablen darstellt, $\dot{x}$ die Zeitableitungen der unbekannten Variablen darstellt, $t$ die Zeit ist und $f'$ die Funktion $f$ der zeitvarianten nichtlinearen Beziehung zwischen den vorherigen Größen ohne die Zwangsbedingungen in der Funktion $g$ ist, die dem Verhalten von $x$ Einschränkungen auferlegt.

4. Computersystem nach Anspruch 1, **dadurch gekennzeichnet, dass** die Simulatorschnittstelle ein System im Fall behandelt, in dem Variable vorhanden sind, die kein Zeitableitungsgegenstück $y$ haben

$$f(\dot{x},x,y,u,t) = 0,$$

wobei $u$ die bekannten Eingangsvariablen darstellt, $x$ die unbekannten Variablen darstellt, $\dot{x}$ die Zeitableitungen der unbekannten Variablen darstellt, $t$ die Zeit ist und $f$ die zeitvariante nichtlineare Beziehung zwischen den Größen ist.

5. Computersystem nach Anspruch 1, **dadurch gekennzeichnet, dass** die Simulatorschnittstelle ein System im Fall behandelt, in dem Variable vorhanden sind, die kein Zeitableitungsgegenstück $y$ haben, und es explizite Zwangsbedingungen für die Zustandsvariablen $x$ gibt

$$f'(\dot{x},x,y,u,t) = 0$$

$$g(x,y,u,t) = 0,$$

wobei $u$ die bekannten Eingangsvariablen darstellt, $x$ die unbekannten Variablen darstellt, $\dot{x}$ die Zeitableitungen der unbekannten Variablen darstellt, $t$ die Zeit ist und $f'$ die Funktion $f$ der zeitvarianten nichtlinearen Beziehung zwischen den vorherigen Größen ohne die Zwangsbedingungen in der Funktion $g$ ist, die dem Verhalten von $x$ Einschränkungen auferlegt.

6. Computersystem nach Anspruch 1, **gekennzeichnet durch** Verwendung der Simulatorschnittstelle im Fall, in dem sich algebraische Zwangsbedingungen für diese Zustandsvariablen während einer Simulation gemischter Form (Mixed-Mode) ändern, um Anfangswerte für Zustandsvariable $x^s$ in einem System zu berechnen, dessen Funktion ein Verhalten in verschiedenen stückweisen, stetigen Intervallen beschreibt.

7. Computersystem nach Anspruch 6, **dadurch gekennzeichnet, dass** die Simulatorschnittstelle ein System in der allgemeinen differential-algebraischen Gleichungsform (Differential and Algebraic Equation; DAE)

$$f_{\alpha_i}(\dot{x},x,u,t) = 0,$$

behandelt, wobei $u$ die bekannten Eingangsvariablen darstellt, $x$ die unbekannten Variablen darstellt, $\dot{x}$ die Zeita-bleitungen der unbekannten Variablen darstellt, $t$ die Zeit ist und $f_{\alpha_i}$ verschiedene Funktionen sind, die das Verhalten in verschiedenen stückweisen, stetigen Intervallen beschreiben und zeitvariante nichtlineare Beziehungen zwischen den Größen sind.

8. Computersystem nach Anspruch 6, **dadurch gekennzeichnet, dass** die Simulatorschnittstelle ein System im Fall behandelt, in dem explizite Zwangsbedingungen für die Zustandsvariablen $x$ bestehen

$$f'_{\alpha_i}(\dot{x},x,u,t) = 0$$

$$g_{\alpha_i}(x,u,t) = 0 \; ,$$

wobei *u* die bekannten Eingangsvariablen darstellt, *x* die unbekannten Variablen darstellt, $\dot{x}$ die Zeitableitungen der unbekannten Variablen darstellt, *t* die Zeit ist und $f_{\alpha_i}$ verschiedene Funktionen sind, die das Verhalten in verschiedenen stückweisen, stetigen Intervallen beschreiben und zeitvariante nichtlineare Beziehungen zwischen den vorherigen Größen ohne die Zwangsbedingungen in der Funktion $g_{\alpha_i}$ sind, die dem Verhalten von *x* Einschränkungen auferlegt.

9. Computersystem nach Anspruch 6, **dadurch gekennzeichnet, dass** die Simulatorschnittstelle ein System im Fall behandelt, in dem Variable vorhanden sind, die kein Zeitableitungsgegenstück *y* haben

$$f_{\alpha_i}(\dot{x},x,y,u,t) = 0,$$

wobei *u* die bekannten Eingangsvariablen darstellt, *x* die unbekannten Variablen darstellt, $\dot{x}$ die Zeitableitungen der unbekannten Variablen darstellt, *t* die Zeit ist und $f_{\alpha_i}$ verschiedene Funktionen sind, die das Verhalten in verschiedenen stückweisen, stetigen Intervallen beschreiben und zeitvariante nichtlineare Beziehungen zwischen den Größen sind.

10. Computersystem nach Anspruch 6, **dadurch gekennzeichnet, dass** die Simulatorschnittstelle ein System im Fall behandelt, in dem Variable vorhanden sind, die kein Zeitableitungsgegenstück *y* haben, und es explizite Zwangsbedingungen für die Zustandsvariablen *x* gibt

$$f'_{\alpha_i}(\dot{x},x,y,u,t) = 0$$

$$g_{\alpha_i}(x,y,u,t) = 0,$$

wobei *u* die bekannten Eingangsvariablen darstellt, *x* die unbekannten Variablen darstellt, $\dot{x}$ die Zeitableitungen der unbekannten Variablen darstellt, *t* die Zeit ist und $f_{\alpha_i}$ verschiedene Funktionen sind, die das Verhalten in verschiedenen stückweisen, stetigen Intervallen beschreiben und zeitvariante nichtlineare Beziehungen zwischen den vorherigen Größen ohne die Zwangsbedingungen in der Funktion $g_{\alpha_i}$ sind, die dem Verhalten von *x* Einschränkungen auferlegt.

11. Computersystem nach Anspruch 1, **gekennzeichnet durch** Verwendung der Simulatorschnittstelle zum Berechnen von Werten für die Zustandsvariablen *x*, wobei die algebraischen Zwangsbedingungen vernachlässigt werden, um zuerst eine Abschätzung für die Zustandsvariablen *x* zu berechnen, und wenn die Zeitableitungen von *x* minimalbedingt sind, Gleichungen der Form $\dot{x}_i = 0$ hinzugefügt werden, die eine Korrektur nach einem Integrationszeitschritt zuführen, um die neuen x-Werte zu berechnen, ohne für die algebraischen Zwangsbedingungen Rechnung abzulegen, wobei die **durch** diese Korrektur berechneten Werte mit den algebraischen Zwangsbedingungen konsistent sind.

12. Computersystem nach Anspruch 11, **dadurch gekennzeichnet, dass** die Simulatorschnittstelle ein System in der allgemeinen differential-algebraischen Gleichungsform (Differential and Algebraic Equation; DAE)

$$f_{\alpha_i}(\dot{x},x,u,t) = 0,$$

behandelt, wobei *u* die bekannten Eingangsvariablen darstellt, *x* die unbekannten Variablen darstellt, $\dot{x}$ die Zeitableitungen der unbekannten Variablen darstellt, *t* die Zeit ist und $f_{\alpha_i}$ verschiedene Funktionen sind, die das Verhalten in verschiedenen stückweisen, stetigen Intervallen beschreiben und zeitvariante nichtlineare Beziehungen zwischen den Größen sind.

13. Computersystem nach Anspruch 11, **dadurch gekennzeichnet, dass** die Simulatorschnittstelle ein System im Fall behandelt, in dem explizite Zwangsbedingungen für die Zustandsvariablen *x* bestehen

$$f'_{\alpha_i}(\dot{x}, x, u, t) = 0$$

$$g_{\alpha_i}(x, u, t) = 0,$$

wobei $u$ die bekannten Eingangsvariablen darstellt, $x$ die unbekannten Variablen darstellt, $\dot{x}$ die Zeitableitungen der unbekannten Variablen darstellt, $t$ die Zeit ist und $f_{\alpha_i}$ verschiedene Funktionen sind, die das Verhalten in verschiedenen stückweisen, stetigen Intervallen beschreiben und zeitvariante nichtlineare Beziehungen zwischen den vorherigen Größen ohne die Zwangsbedingungen in der Funktion $g_{\alpha_i}$ sind, die dem Verhalten von $x$ Einschränkungen auferlegt.

**14.** Computersystem nach Anspruch 11, **dadurch gekennzeichnet, dass** die Simulatorschnittstelle ein System in dem Fall behandelt, in dem Variable vorhanden sind, die kein Zeitableitungsgegenstück $y$ haben

$$f_{\alpha_i}(\dot{x}, x, y, u, t) = 0,$$

wobei $u$ die bekannten Eingangsvariablen darstellt, $x$ die unbekannten Variablen darstellt, $\dot{x}$ die Zeitableitungen der unbekannten Variablen darstellt, $t$ die Zeit ist und $f_{\alpha_i}$ verschiedene Funktionen sind, die das Verhalten in verschiedenen stückweisen, stetigen Intervallen beschreiben und zeitvariante nichtlineare Beziehungen zwischen den Größen sind.

**15.** Computersystem nach Anspruch 11, **dadurch gekennzeichnet, dass** die Simulatorschnittstelle ein System im Fall behandelt, in dem Variable vorhanden sind, die kein Zeitableitungsgegenstück $y$ haben, und es explizite Zwangsbedingungen für die Zustandsvariablen $x$ gibt

$$f'_{\alpha_i}(\dot{x}, x, y, u, t) = 0$$

$$g_{\alpha_i}(x, y, u, t) = 0,$$

wobei $u$ die bekannten Eingangsvariablen darstellt, $x$ die unbekannten Variablen darstellt, $\dot{x}$ die Zeitableitungen der unbekannten Variablen darstellt, $t$ die Zeit ist und $f_{\alpha_i}$ verschiedene Funktionen sind, die das Verhalten in verschiedenen stückweisen, stetigen Intervallen beschreiben und zeitvariante nichtlineare Beziehungen zwischen den vorherigen Größen ohne die Zwangsbedingungen in der Funktion $g_{\alpha_i}$ sind, die dem Verhalten von $x$ Einschränkungen auferlegt.

**16.** Computersystem nach einem der Ansprüche 1 bis 15, **gekennzeichnet durch** die Integration eines Korrekturschrittes in einen numerischen Solver **durch** Verwendung einer zusätzlichen Korrekturfunktion, wobei dieser Korrekturschritt auf alle Zwischenintegrationspunkte wirkt, einschließlich jener, die **durch** den Solver nicht angenommen werden, weil sie einen zu großen Fehler ergeben würden.

**17.** Computersystem nach einem der Ansprüche 1 bis 16, **gekennzeichnet durch** ein Mittel zum Umgehen der Simulatorschnittstelle zur Initialisierung des ersten stückweisen, stetigen Verhaltens, um die direkte Initialisierung der Simulatorzustandsvariablen **durch** den Modellierer zu erlauben.

**18.** Computersystem nach einem der Ansprüche 6 bis 15, **gekennzeichnet durch** einen Diskretereignis-Iterationsmechanismus in der Simulationsschnittstelle, um sicherzustellen, dass das System aktiver Gleichungen mit den Zustandsvariablenwerten, die zum Auswählen des aktiven Systems der Gleichungen verwendet werden, konsistent ist.

**19.** Computersystem nach einem der Ansprüche 1 bis 18, **dadurch gekennzeichnet, dass** die Systeme von Gleichungen mit expliziten Initialisierungszwangsbedingungen der Form

$$h_{\alpha_i}\left(x(t),\ x\left(t^-\right),\ t\right)\ =\ 0$$

ergänzt sind, wobei $x(t^-)$ der linke zeitliche Grenzwert von x(t) ist.

**20.** Computersystem nach Anspruch 19, **gekennzeichnet durch** einen Mechanismus zur Stattgabe unmittelbarer weiterer diskreter aufzurufender Ereignisse, um ein neues System von Gleichungen $\alpha_{i+1}$ vor vorrückendem Zeittakt mittels eines numerischen Solvers auszuwählen, wenn Gleichungen der Form

$$h_{\alpha_i}\left(x(t),\ x\left(t^-\right),\ t\right)\ =\ 0$$

vorhanden sind.

**21.** Computersystem nach einem der Ansprüche 1 bis 20, **gekennzeichnet durch** eine Schnittstelle zum Überführen der konsistenten Anfangswerte $x$ vom erweiterten Zustand in die Zustandsvariablen $x^s$, wie sie **durch** den numerischen Solver benutzt werden, wobei das System von Gleichungen algebraisch manipuliert wird, bevor es dem numerischen Solver zugeführt wird, um in expliziter ordinärer Differentialgleichungsform (ODE; Ordinary Differential Equation) zu sein, oder wobei es eine differential-algebraische Gleichung (Differential and Algebraic Equation; DAE) von einer Komplexität ist, mit welcher der numerische Solver umgehen kann, wobei im Fall eines reduzierten Satzes von Zuständen $x^r$ die bevorzugte Ausführung einen Untersatz von $x$ als $x^r$ nimmt, so dass $X^r \subset X$, und im Fall, dass ein anderer Satz von reduzierten Zuständen gewählt wird, das algebraische Werkzeug die entsprechenden algebraischen Beziehungen zuführen muss, um fähig zu sein, die konsistenten Anfangsbedingungen zu den reduzierten Zustandsvariablenwerten überzuführen.

**22.** Computersystem nach einem der Ansprüche 6 bis 15, **gekennzeichnet durch** eine Simulationsschnittstelle zum Mischen differential-algebraischer Gleichungen (Differential and Algebraic Equations; DAEs) in verschiedener Form, um während verschiedener Stufen $\alpha_i$ der Simulation aktiv zu sein, wobei diese Operation Variable enthält, die sich davon, Teil von $X^r$ zu sein, dahin, Teil von Y zu sein, ändern.

**23.** Computersystem nach einem der Ansprüche 6 bis 15, **gekennzeichnet durch** eine Simulationsschnittstelle zum Mischen differential-algebraischer Gleichungen (Differential and Algebraic Equations; DAEs) in verschiedener Form und mit verschiedenen Variablen, so dass sich die Anzahl von erweiterten Zustandsvariablen ändert und die Anzahl von algebraischen Variablen nicht angepasst ist, wobei diese Systeme eine explizite Abbildung zwischen den Variablen in verschiedenen Betriebsintervallen $\alpha_i$ erfordern.

**Revendications**

**1.** Système informatique contenant une structure de modèle de simulation numérique de systèmes physiques reposant sur des équations différentielles soumises à des contraintes algébriques sur des variables d'état représentant des quantités physiques pour générer des trajectoires de comportement pour un modèle de système par des solveurs numériques, ledit modèle de système étant d'un ordre réduit en ce qui concerne son nombre de variables d'état modélisées x, qui apparaissent sous une forme dérivée en fonction du temps dans le système d'équations, lesdites contraintes algébriques imposant des restrictions sur le comportement de x et donc, diminuant son nombre de degrés de liberté, et des valeurs initiales étant fournies pour chacune de ces variables d'état x, les valeurs initiales fournies pouvant ne pas être cohérentes avec lesdites contraintes algébriques,

ladite structure de modèle de système comprenant une interface de simulation comprenant six modules en interaction, spécifiquement :

- un module de sélection de modèle actif choisissant pour chaque mode $\alpha_i$ un jeu actif d'équations $f_{\alpha_i}$, qui décrivent un comportement de système continu ainsi qu'un jeu d'équations de réinitialisation explicites, $h_{\alpha_i}$ ;
- un module de calcul de valeur initiale calculant de nouvelles valeurs pour les variables d'état cohérentes avec les équations instantanées du comportement dynamique continu actif, à condition que le jeu actif d'équations de modèle et les valeurs actuelles du jeu étendu de variables d'état du système soient donnés ;

- un module de moteur algébrique manipulant lesdites équations de modèle actives sous une forme ayant une complexité qui peut être traitée par le solveur numérique utilisé, lesdites contraintes algébriques étant négligées et les dérivées de variables d'état étant définies à 0 jusqu'à ce que toutes les dérivées de variable d'état puissent être calculées, si le jeu étendu de variables d'état, x, est utilisé, et la différentiation des équations étant requise pour arriver à un vecteur d'état réduit, $x^r$, si un système d'ordre minimal est utilisé, le vecteur d'état résultant qui est utilisé pour la simulation, x ou $x^r$, étant appelé $x^s$ ;

- un module de mappage de valeur initiale mappant les valeurs initiales cohérentes calculées, x, avec le vecteur d'état pour simulation, $x^s$, comme déterminé par le système d'équations qui est fourni audit solveur numérique ;

- un module de solveur numérique générant des comportements continus jusqu'à ce qu'un temps d'arrêt donné soit atteint ou qu'un événement discret soit détecté, à condition qu'un système d'équations et un jeu d'états initiaux soient donnés ; et

- un module de détection et de localisation d'événement discret détectant si des événements discrets se produisent, localisant leur temps d'apparition et les valeurs correspondantes des variables du système, x, et modifiant le système d'équations actives ;

dans lequel la sortie dudit module de sélection de modèle actif est appliquée à l'entrée dudit module de calcul de valeur initiale ainsi qu'à l'entrée dudit module de moteur algébrique, la sortie dudit module de moteur algébrique est appliquée à l'entrée dudit module de mappage de valeur initiale ainsi qu'à l'entrée dudit module de solveur numérique, la sortie dudit module de calcul de valeur initiale est appliquée à l'entrée dudit dudit module de détection et de localisation d'événement discret ainsi qu'à l'entrée dudit module de mappage de valeur initiale, la sortie dudit module de mappage de valeur initiale est appliquée à l'entrée dudit module de solveur numérique, la sortie dudit module de solveur numérique est appliquée à l'entrée dudit module de détection et de localisation d'événement discret, et la sortie dudit module de détection et de localisation d'événement discret est appliquée à l'entrée dudit module de sélection de modèle actif ainsi qu'à l'entrée dudit module de calcul de valeur initiale,

et calculer, sur la base des valeurs initiales fournies des variables d'état modélisées x, des valeurs initiales pour des variables d'état $x^s$ qui sont cohérentes avec lesdites contraintes algébriques, en intégrant lesdites équations différentielles pour lesdites variables d'état modélisées x au cours d'un intervalle infinitésimal de temps de $t_0^-$ à $t_0$, précédant immédiatement le temps de début $t_0$ de comportement continu, conduisant à des équations reliant $x(t_0^-)$ et $x(t_0)$, où $x(t_0^-)$ sont connus comme étant les valeurs initiales fournies pour les variables d'état modélisées x et $x(t_0)$ sont les valeurs initiales souhaitées des variables d'état $x^s$ à rendre cohérentes avec les contraintes algébriques, et en calculant à partir de ces équations en combinaison avec lesdites contraintes algébriques les $x(t_0)$.

2. Système informatique selon la revendication 1, **caractérisé en ce que** ladite interface de simulation traite un système sous la forme générale d'une équation différentielle et algébrique (DAE)

$$f(\dot{x},x,u,t)=0,$$

où u représente les variables d'entrée connues, x représente les variables inconnues, $\dot{x}$ représente les dérivées en fonction du temps des variables inconnues, t est le temps, et f est la relation non linéaire variant en fonction du temps entre les quantités.

3. Système informatique selon la revendication 1, **caractérisé en ce que** l'interface de simulation traite un système dans le cas où des contraintes explicites sur les variables d'état existent

$$f'(\dot{x}, x, u, t) = 0$$

$$g(x, u, t) = 0,$$

où u représente les variables d'entrée connues, x représente les variables inconnues, $\dot{x}$ représente les dérivées en fonction du temps des variables inconnues, t est le temps, et f est la fonction f de la relation non linéaire variant en fonction du temps entre les quantités précédentes sans les contraintes dans la fonction g imposant des restrictions sur le comportement de x.

4. Système informatique selon la revendication 1, **caractérisé en ce que** l'interface de simulation traite un système dans le cas où des variables sont présentes qui n'ont pas une contrepartie de dérivée en fonction du temps y

$$f(\dot{x},x,y,u,t)=0,$$

où u représente les variables d'entrée connues, x représente les variables inconnues, $\dot{x}$ représente les dérivées en fonction du temps des variables inconnues, t est le temps, et f est la relation non linéaire variant en fonction du temps entre les quantités.

5. Système informatique selon la revendication 1, **caractérisé en ce que** l'interface de simulation traite un système dans le cas où des variables sont présentes qui n'ont pas de contrepartie dérivée en fonction du temps y, et il existe des contraintes explicites sur les variables d'état x

$$f'(\dot{x},x,y,u,t)=0$$

$$g(x, y, u, t) = 0,$$

où u représente les variables d'entrée connues, x représente les variables inconnues, $\dot{x}$ représente les dérivées en fonction du temps des variables inconnues, t est le temps, et f est la fonction f de la relation non linéaire variant en fonction du temps entre les quantités précédentes sans les contraintes dans la fonction g imposant des restrictions sur le comportement de x.

6. Système informatique selon la revendication 1, **caractérisé par** l'utilisation de ladite interface de simulation, dans le cas où des contraintes algébriques sur ces variables d'état changent au cours d'une simulation en mode mixte, pour calculer des valeurs initiales pour les variables d'état $x^s$ dans un système dont la fonction décrit le comportement dans différents intervalles continus élémentaires.

7. Système informatique selon la revendication 6, **caractérisé en ce que** l'interface de simulation traite un système sous la forme générale d'une équation différentielle et algébrique (DAE)

$$f_{\alpha 1}(\dot{x},x,u,t) = 0,$$

où u représente les variables d'entrée connues, x représente les variables inconnues, $\dot{x}$ représente les dérivées en fonction du temps des variables inconnues, t est le temps, et $f_{\alpha 1}$ sont différentes fonctions décrivant le comportement dans différents intervalles continus élémentaires et étant des relations non linéaires variant en fonction du temps entre les quantités.

8. Système informatique selon la revendication 6, **caractérisé en ce que** l'interface de simulation traite un système dans le cas où des contraintes explicites sur les variables d'état existent

$$f'_{\alpha_i}(\dot{x},x,u,t)=0$$

$$g_{\alpha_i}(x, u, t) = 0,$$

où u représente les variables d'entrée connues, x représente les variables inconnues, $\dot{x}$ représente les dérivées en fonction du temps des variables inconnues, t est le temps, et $f_{\alpha_i}$ sont différentes fonctions décrivant le comportement dans différents intervalles continus élémentaires et étant des relations non linéaires variant en fonction du temps entre les quantités précédentes sans les contraintes dans la fonction $g_{\alpha_i}$ imposant des restrictions sur le comportement de x.

9. Système informatique selon la revendication 6, **caractérisé en ce que** l'interface de simulation traite un système dans le cas où des variables sont présentes qui n'ont pas une contrepartie de dérivée en fonction du temps y

$$f_{\alpha 1}(\dot{x}, x, y, u, t) = 0,$$

où u représente les variables d'entrée connues, x représente les variables inconnues, $\dot{x}$ représente les dérivées en fonction du temps des variables inconnues, t est le temps, et $f_{\alpha i}$ sont différentes fonctions décrivant le comportement dans différents intervalles continus élémentaires et étant des relations non linéaires variant en fonction du temps entre les quantités.

10. Système informatique selon la revendication 6, **caractérisé en ce que** l'interface de simulation traite un système dans le cas où des variables sont présentes qui n'ont pas de contrepartie dérivée en fonction du temps y, et il existe des contraintes explicites sur les variables d'état x

$$f'_{\alpha_i}(\dot{x}, x, y, u, t) = 0$$

$$g_{\alpha_i}(x, y, u, t) = 0,$$

où u représente les variables d'entrée connues, x représente les variables inconnues, $\dot{x}$ représente les dérivées en fonction du temps des variables inconnues, t est le temps, et $f_{\alpha i}$ sont différentes fonctions décrivant le comportement dans différents intervalles continus élémentaires et étant des relations non linéaires variant en fonction du temps entre les quantités précédentes sans les contraintes dans la fonction $g_{\alpha 1}$ imposant des restrictions sur le comportement de x.

11. Système informatique selon la revendication 1, **caractérisé par** l'utilisation de ladite interface de simulation pour calculer des valeurs pour les variables d'état x, les contraintes algébriques étant négligées pour calculer dans un premier temps une pré-estimation pour les variables d'état x, et si les dérivées en fonction du temps de x sont sous-contraintes, des équations de la forme $\dot{x}_i = 0$ sont ajoutées, en appliquant une correction après un pas de temps d'intégration pour calculer les nouvelles valeurs x sans tenir compte des contraintes algébriques, les valeurs calculées par cette correction étant cohérentes avec lesdites contraintes algébriques.

12. Système informatique selon la revendication 11, **caractérisé en ce que** l'interface de simulation traite un système sous la forme générale d'une équation différentielle et algébrique (DAE)

$$f_{\alpha_i}(\dot{x}, x, u, t) = 0,$$

où u représente les variables d'entrée connues, x représente les variables inconnues, $\dot{x}$ représente les dérivées en fonction du temps des variables inconnues, t est le temps, et $f_{\alpha i}$ sont différentes fonctions décrivant le comportement dans différents intervalles continus élémentaires et étant des relations non linéaires variant en fonction du temps entre les quantités.

13. Système informatique selon la revendication 11, **caractérisé en ce que** l'interface de simulation traite un système dans le cas où des contraintes explicites sur les variables d'état existent

$$f'_{\alpha_i}(\dot{x}, x, u, t) = 0$$

$$g_{\alpha_i}(x, u, t) = 0,$$

où u représente les variables d'entrée connues, x représente les variables inconnues, $\dot{x}$ représente les dérivées en fonction du temps des variables inconnues, t est le temps, et $f_{\alpha i}$ sont différentes fonctions décrivant le comportement dans différents intervalles continus élémentaires et étant des relations non linéaires variant en fonction du temps entre les quantités précédentes sans les contraintes dans la fonction $g_{\alpha_i}$ imposant des restrictions sur le comportement de x.

14. Système informatique selon la revendication 11, **caractérisé en ce que** l'interface de simulation traite un système dans le cas où des variables sont présentes qui n'ont pas une contrepartie de dérivée en fonction du temps y

$$f_{\alpha_i}(\dot{x}, x, y, u, t) = 0,$$

où u représente les variables d'entrée connues, x représente les variables inconnues, $\dot{x}$ représente les dérivées en fonction du temps des variables inconnues, t est le temps, et $f_{\alpha_i}$ sont différentes fonctions décrivant le comportement dans différents intervalles continus élémentaires et étant des relations non linéaires variant en fonction du temps entre les quantités.

**15.** Système informatique selon la revendication 11, **caractérisé en ce que** l'interface de simulation traite un système dans le cas où des variables sont présentes qui n'ont pas de contrepartie dérivée en fonction du temps y, et il existe des contraintes explicites sur les variables d'état x

$$f'_{\alpha_i}(\dot{x}, x, y, u, t) = 0$$

$$g_{\alpha_i}(x, y, u, t) = 0,$$

où u représente les variables d'entrée connues, x représente les variables inconnues, $\dot{x}$ représente les dérivées en fonction du temps des variables inconnues, t est le temps, et $f_{\alpha_i}$ sont différentes fonctions décrivant le comportement dans différents intervalles continus élémentaires et étant des relations non linéaires variant en fonction du temps entre les quantités précédentes sans les contraintes dans la fonction $g_{\alpha_i}$ imposant des restrictions sur le comportement de x.

**16.** Système informatique selon l'une quelconque des revendications 1 à 15, **caractérisé par** l'intégration d'une étape de correction dans un solveur numérique par utilisation d'une fonction de correction supplémentaire, cette étape de correction opérant sur tous les points d'intégration intermédiaires, y compris ceux qui ne sont pas acceptés par le solveur parce qu'ils donneraient lieu à une erreur trop importante.

**17.** Système informatique selon l'une quelconque des revendications 1 à 16, **caractérisé par** un moyen pour contourner l'interface de simulation pour l'initialisation du premier comportement continu élémentaire pour permettre l'initialisation directe des variables d'état du simulateur par le modéliseur.

**18.** Système informatique selon l'une quelconque des revendications 6 à 15, **caractérisé par** un mécanisme d'itération d'événement discret dans l'interface de simulation pour assurer que le système d'équations actives soit cohérent avec les valeurs de variable d'état utilisées pour sélectionner le système d'équations actives.

**19.** Système informatique selon l'une quelconque des revendications 1 à 18, **caractérisé en ce que** les systèmes d'équations sont complétés par des contraintes d'initialisation explicites de la forme

$$h_{\alpha_i}(x(t), x(t^-), t) = 0,$$

où $x(t^-)$ est la valeur limite gauche dans le temps de $x(t)$.

**20.** Système informatique selon la revendication 19, **caractérisé par** un mécanisme pour permettre que des événements discrets immédiatement ultérieurs soient appelés pour sélectionner un nouveau système d'équations $\alpha_{i+1}$, avant d'avancer dans le temps au moyen d'un solveur numérique si des équations de la forme

$$h_{\alpha_i}(x(t), x(t^-), t) = 0$$

sont présentes.

**21.** Système informatique selon l'une quelconque des revendications 1 à 20, **caractérisé par** une interface pour transférer les valeurs initiales cohérentes x de l'état étendu aux variables d'état $x^s$ utilisées par le solveur numérique, manipuler algébriquement le système d'équations avant qu'il soit soumis au solveur numérique de manière à être sous une forme d'ODE (équation différentielle ordinaire) explicite, ou étant une DAE d'une complexité que le solveur numérique peut traiter, dans le cas d'un jeu réduit d'états $x^r$ l'implémentation préférée prend un sous-ensemble de x en tant que $x^r$, de sorte que $x^r$ c x, et dans le cas où un autre jeu d'états réduits est choisi, le moteur algébrique doit fournir les relations algébriques correspondantes pour être capable de transférer les conditions initiales cohérentes aux valeurs de variable d'état réduites.

22. Système informatique selon l'une quelconque des revendications 6 à 15, **caractérisé par** une interface de simulation pour mélanger des DAE sous une forme différente pour être active durant différents stades $\alpha_i$ de la simulation, cette opération comprenant des variables qui changent de faisant partie de $x^r$ à faisant partie de Y.

23. Système informatique selon l'une quelconque des revendications 6 à 15, **caractérisé par** une interface de simulation pour mélanger des DAE sous une forme différente et avec différentes variables de sorte que le nombre de variables d'état étendues change et que le nombre de variables algébriques ne correspondent pas, ces systèmes nécessitant un mappage explicite entre les variables dans différents intervalles d'opération $\alpha_i$.

Fig.1

Fig.2

Fig.3

Fig.4

Fig.5

Fig.6

Fig.7

Fig.8

EP 1 143 347 B1

```
                    ┌──────────────────────┐
                    │  get guarded equations│
                    │  and initial conditions│
                    └──────────┬───────────┘
                               ▼
    ┌───────────────►┌──────────────────────┐◄──────────────┐
    │                │ determine continuous  │               │
    │                │ behavior equations, f │               │
    │                └──────────┬───────────┘               │
    │                           ▼                            │
    │                ┌──────────────────────┐               │
    │                │  integrate f from     │               │
    │                │      t̄ to t           │               │
    │                └──────────┬───────────┘               │
    │                           ▼                            │
    │                ┌──────────────────────┐               │
    │                │ add explicit reinitialization         │
    │                │      constraints      │               │
    │  N             └──────────┬───────────┘               │
    │        ╱╲                 ▼                            │
    │      ╱     ╲   Y ┌──────────────────────┐             │
    └────◄correction├─►│  substitute current   │             │
         ╲ event  ╱    │  state, x, as x(t̄)   │             │
           ╲   ╱       └──────────┬───────────┘             │
            ╲╱                    ▼                          │
                      ┌──────────────────────┐              │
                      │   compute new         │              │
                      │     state x(t)        │              │
                      └──────────┬───────────┘              │
                                 ▼                           │
                          ╱╲                                 │
                        ╱     ╲   Y                          │
                       ◄detect discrete├───────────────────►┘
                        ╲ events ╱
                          ╲   ╱
                           ╲╱
                          N ▼
                      ┌──────────────────────┐
                      │  compute simulation   │
                      │     model, f'         │
                      └──────────┬───────────┘
                                 ▼
                      ┌──────────────────────┐
                      │ initialize the        │
                      │ simulation state x' with x│
                      └──────────┬───────────┘
    ┌──────────────────┐         ▼
    │ find event time   │  ┌──────────────────────┐◄───┐
    │ and state values  │  │  advance time over     │    │
    └────────▲─────────┘  │  one integration interval│   │
             │            └──────────┬───────────┘    │
             │  Y                    ▼                 │
             └──────────────◄ detect discrete ╲        │
                             ╲  events  ╱               │
                               ╲   ╱                    │
                              N ▼                       │
                          ╱╲                            │
                        ╱     ╲   N                     │
                       ◄ detect end ├───────────────────┘
                        ╲  time  ╱
                          ╲   ╱
                           ╲╱
                          Y ▼
```

# Fig.9

35